# EUROPEAN PATENT APPLICATION

(11) **EP 4 575 638 A2**
(43) Date of publication of application: **25.06.2025**
(21) Application number: 24191733.5
(22) Date of filing: 30.07.2024
(51) Int. Cl.: G03F 7/00, H01L 23/00, H01L 23/50, H01L 25/065

(54) **SEMICONDUCTOR DEVICE, SEMICONDUCTOR PACKAGE INCLUDING THE SEMICONDUCTOR DEVICE, AND METHOD OF MANUFACTURING THE SEMICONDUCTOR DEVICE**

(30) Priority: 19.12.2023 KR 20230186299
(71) Applicant: Samsung Electronics Co., Ltd, Suwon-si, Gyeonggi-do 16677 (KR)
(72) Inventor: BAEK, Seokcheon, 16677 Suwon-si (KR); KIM, Seohyun, 16677 Suwon-si (KR); BAIK, Min, 16677 Suwon-si (KR); LEE, Myeongjun, 16677 Suwon-si (KR); LEE, Jiho, 16677 Suwon-si (KR)
(74) Representative: Marks & Clerk LLP

(57) **Abstract**

Provided are semiconductor devices, which are capable of contributing to chip size reduction and ensuring process stability, semiconductor packages including the semiconductor devices, and methods of manufacturing the semiconductor devices. The semiconductor device includes a first semiconductor chip of a first type and a second semiconductor chip of a second type having rectangular shapes with a same size, wherein the first semiconductor chip and the second semiconductor chip are included in a plurality of semiconductor chips corresponding to 1-shot in an exposure process to be adjacent to each other in a first direction, and when the first semiconductor chip and the second semiconductor chip are arranged adjacent to each other in a first direction in the 1-shot, the first semiconductor chip and the second semiconductor chip are mirror-symmetrical to each other in the 1-shot with respect to an axis in a second direction perpendicular to the first direction.

## Description

### BACKGROUND

The inventive concepts relate to semiconductor devices, and more particularly, to two types of semiconductor devices, semiconductor packages including the semiconductor devices, and/or methods of manufacturing the semiconductor devices.

In response to demands for miniaturization, multi-functionality, and high performance of electronic products, high-capacity semiconductor memory devices are required. In order to provide high-capacity semiconductor memory devices, the degree of integration needs to increase. Because the degree of integration of conventional two-dimensional (2D) semiconductor memory devices is mainly determined by the area occupied by a unit memory cell, the degree of integration of 2D semiconductor memory devices is increasing but is still restrictive. Accordingly, three-dimensional (3D) semiconductor memory devices that increase memory capacity by stacking a plurality of memory cells on a substrate in a vertical direction are under development. For example, vertical NAND (VNAND) has already been commercialized and used.

### SUMMARY

The inventive concepts provide semiconductor devices, which are capable of contributing to chip size reduction and ensuring process stability, semiconductor packages including the semiconductor device, and/or methods of manufacturing the semiconductor device.

In addition, the technical objectives of the inventive concepts are not limited to the above object, and other objects that are not mentioned herein will be clearly understood by those of ordinary skill in the art from the following description.

According to an aspect of the inventive concepts, a semiconductor device includes a first semiconductor chip of a first type and a second semiconductor chip of a second type having rectangular shapes with a same size, wherein the first semiconductor chip and the second semiconductor chip are included in a plurality of semiconductor chips corresponding to 1-shot in an exposure process, and when the first semiconductor chip and the second semiconductor chip are arranged adjacent to each other in a first direction in the 1-shot, the first semiconductor chip and the second semiconductor chip are mirror-symmetrical to each other in the 1-shot with respect to an axis in a second direction perpendicular to the first direction.

According to another aspect of the inventive concepts, a semiconductor package includes a package substrate, a first semiconductor chip of a first type on the package substrate, and a second semiconductor chip of a second type stacked on the first semiconductor chip, wherein the first semiconductor chip and the second semiconductor chip have rectangular shapes with a same size, and when arranged in the first direction, the first semiconductor chip and the second semiconductor chip are mirror-symmetrical to each other with respect to a reference line extending in a second direction perpendicular to the first direction.

According to another aspect of the inventive concepts, a semiconductor package includes a package substrate, at least one first semiconductor chip of a first type on the package substrate, and at least one second semiconductor chip of a second type on the package substrate, wherein the first semiconductor chip and the second semiconductor chip have rectangular shapes with a same size, when the at least one first semiconductor chip and the at least one second semiconductor chip are arranged adjacent to each other in a first direction in a 1-shot in an exposure process, the at least one first semiconductor chip and the at least one second semiconductor chip are mirror-symmetrical to each other with respect to a reference line extending in a second direction perpendicular to the first direction, and the at least one first semiconductor chip of the first type and the at least one second semiconductor chip of the second type are alternately stacked on the package substrate.

According to another aspect of the inventive concepts, a method of manufacturing a semiconductor device includes preparing a mask, forming a pattern on a wafer through an exposure process using the mask, determining whether a semiconductor device is completely formed, in response to a result of the determining indicating that the semiconductor device has been completely formed, singulating the wafer into a plurality of semiconductor chips, and in response to the result of the determining indicating that the semiconductor device has not been completely formed, returning to the preparing of the mask to prepare another mask corresponding to a next pattern, wherein, in the forming of the pattern, 1-shot, which is an area of the pattern transferred through one exposure process is formed to have a structure including the plurality of semiconductor chips that are mirror-symmetrical to each other, or origin-symmetrical to each other.

At least some of the above and other features of the invention are set out in the claims.

### BRIEF DESCRIPTION OF THE DRAWINGS

Example embodiments will be more clearly understood from the following detailed description taken in conjunction with the accompanying drawings in which:
FIGS. 1A and 1B are respectively a plan view and a cross-sectional view of a semiconductor device according to an example embodiment;
FIGS. 2A to 2E are plan views of semiconductor devices according to some example embodiments;
FIG. 3 is a flowchart schematically illustrating a method of manufacturing a semiconductor device, according to an example embodiment;
FIGS. 4A to 4C are respectively plan views and a cross-sectional view for describing the concept of 1-shot of mirror symmetry in the method of manufacturing the semiconductor device illustrated in FIG. 3;
FIGS. 5A and 5B are plan views illustrating other forms of 1-shot of mirror symmetry;
FIGS. 6A to 6D are respectively plan views and cross-sectional views illustrating the form of 1-shot according to comparative examples;
FIGS. 7A to 7C are respectively a plan view and cross-sectional views for describing the concept of 1-shot of origin symmetry in the method of manufacturing the semiconductor device illustrated in FIG. 3;
FIGS. 8A to 8C are plan views illustrating other forms of 1-shot of origin symmetry;
FIGS. 9A and 9B are plan views illustrating two 1-shots of mirror symmetry arranged adjacent to each other;
FIGS. 10A and 10B are plan views illustrating two 1-shots of origin symmetry arranged adjacent to each other;
FIGS. 11A and 11B are respectively a plan view and a cross-sectional view of a semiconductor package including a semiconductor device, according to an example embodiment;
FIGS. 12A and 12B are respectively a plan view and a cross-sectional view of a semiconductor package including a semiconductor device, according to an example embodiment;
FIGS. 13A and 13B are respectively a plan view and a cross-sectional view of a semiconductor package including a semiconductor device, according to an example embodiment;
FIGS. 14A to 14C are respectively a plan view and cross-sectional views of a semiconductor package including a semiconductor device, according to an example embodiment; and
FIGS. 15A and 15B are respectively a plan view and a cross-sectional view of a semiconductor package including a semiconductor device, according to an example embodiment.

### DETAILED DESCRIPTION

Hereinafter, some example embodiments will be described in detail with reference to the accompanying drawings. The same elements in the drawings are denoted by the same reference numerals, and redundant descriptions thereof are omitted. Reference to various directions (e.g. right, left, above, below) are in reference to orientation of the semiconductor devices as shown in figures. Accordingly, these directions to not necessarily imply any particular orientation of the semiconductor device in use.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

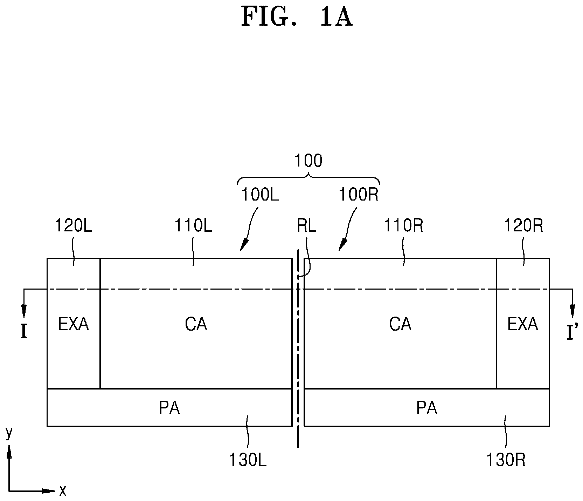

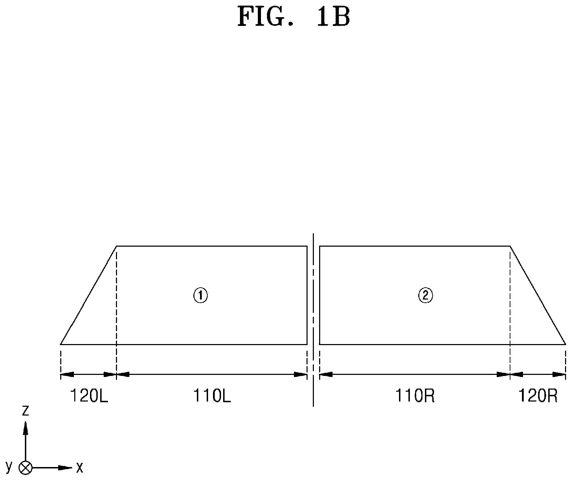

FIGS. 1A and 1B are respectively a plan view and a cross-sectional view of a semiconductor device according to an example embodiment. FIG. 1B is a cross-sectional view taken along line I-I' of FIG. 1A.

Referring to FIGS. 1A and 1B, a semiconductor device 100 according to the present example embodiment may include two types of semiconductor chips. For example, the semiconductor device 100 according to the present example embodiment may include a first semiconductor chip 100L and a second semiconductor chip 100R. The first semiconductor chip 100L and the second semiconductor chip 100R may have a mirror-symmetrical structure with respect to an axis in a y direction. For example, the first semiconductor chip 100L may include a first cell area 110L, a first extension area 120L, and a first peripheral area 130L, and the second semiconductor chip 100R may include a second cell area 1 10R, a second extension area 120R, and a second peripheral area 130R.

When the first semiconductor chip 100L and the second semiconductor chip 100R are arranged adjacent to each other in an x direction and the longer side of each of the first semiconductor chip 100L and the second semiconductor chip 100R is arranged in the x direction (e.g. extending in the x-direction), the first extension area 120L of the first semiconductor chip 100L may be arranged on the left side of the first cell area 110L in the x direction and the first peripheral area 130L of the first semiconductor chip 100L may be disposed below the first cell area 110L and the first extension area 120L in the y direction. In addition, the second extension area 120R of the second semiconductor chip 100R may be arranged on the right side of the second cell area 110R in the x direction, and the second peripheral area 130R of the second semiconductor chip 100R may be disposed below the second cell area 110R and the second extension area 120R in the y direction.

When a one-dot chain line (shown in FIG. 1A) extending between the first semiconductor chip 100L and the second semiconductor chip 100R in the y direction is a reference line RL, the first semiconductor chip 100L and the second semiconductor chip 100R may be mirror-symmetrical to each other with respect to the reference line RL. On the other hand, when the reference line RL is the axis in the y direction, the first semiconductor chip 100L and the second semiconductor chip 100R may be said to be mirror-symmetrical to each other with respect to the axis in the y direction. The meaning of the mirror symmetry between the first semiconductor chip 100L and the second semiconductor chip 100R is not limited to mirror symmetry between areas in the plan view of FIG. 1A, and elements included in the first cell area 110L and the second cell area 110R may also be mirror-symmetrical to each other (e.g. within a body of each of the first cell area 110L and the second cell area 11 0R). In addition, elements included in the first extension area 120L and the second extension area 120R may be mirror-symmetrical to each other, and elements included in the first peripheral area 130L and the second peripheral area 130R may also be mirror-symmetrical to each other.

A vertical NAND (VNAND), which is a vertical non-volatile memory device, is described in more detail. In general, the VNAND may include a vertical channel structure disposed in a two-dimensional array structure on a substrate of a cell area, and a stacked structure including gate electrode layers and interlayer insulating layers alternately stacked along sidewalls of the vertical channel structure on the substrate. The stacked structure may extend in the x direction in the cell area, and the gate electrode layer may constitute an electrode pad in the extension area. In some example embodiments, the electrode pad may also be referred to as a word line pad. In the extension area, the electrode pad may have a stepped structure. For example, the electrode pad may extend shorter from the cell area as the distance from the substrate increases and may extend longer from the cell area as the distance from the substrate decreases.

On the other hand, the peripheral area may be arranged outside the cell area and the extension area, and peripheral circuits may be arranged in the peripheral area. The peripheral circuit may include high-voltage and/or low-voltage transistors and passive elements, such as resistors and capacitors. In addition, the peripheral circuit may include wirings connected to the transistors and the passive elements. The wirings of the peripheral circuit may be connected to bit lines of the cell area. In addition, the wirings of the peripheral circuit may be connected to electrode pads of the extension area.

In the case that the first semiconductor chip 100L is a VNAND, the stacked structure may extend to the left side of the first cell area 110L in the x direction, and the electrode pad having the stepped structure may be formed in the first extension area 120L arranged on the left side of the first cell area 110L. In addition, in the case that the second semiconductor chip 100R is the VNAND, the stacked structure may extend to the right side of the second cell area 110R in the x direction, and the electrode pad having the stepped structure may be formed in the second extension area 120R arranged on the right side of the second cell area 1 10R. In FIG. 1B, the stepped structure of each of the first extension area 120L and the second extension area 120R is simply illustrated as an inclined surface for convenience.

In a plan view, the arrangement positions of the vertical channel structures of the first cell area 110L may be mirror-symmetrical to the arrangement positions of the vertical channel structures of the second cell area 110R with respect to the axis in the y direction. In addition, the direction and length of the stacked structure extending from the first cell area 110L to the first extension area 120L may be mirror-symmetrical to the direction and length of the stacked structure extending from the second cell area 110R to the second extension area 120R with respect to the axis in the y direction. Furthermore, because mirror symmetry is formed with respect to the axis in the y direction, the stepped structures of the first extension area 120L and the second extension area 120R may have opposite inclinations.

On the other hand, the first peripheral area 130L may be disposed below the first cell area 110L and the first extension area 120L in the y direction. In addition, because mirror symmetry is formed with respect to the axis in the y direction, the second peripheral area 130R may also be disposed below the second cell area 110R and the second extension area 120R in the y direction. Furthermore, the positions and directions of elements and wirings in the first peripheral area 130L may be mirror-symmetrical to the positions and directions of elements and wirings in the second peripheral area 130R with respect to the axis in the y direction.

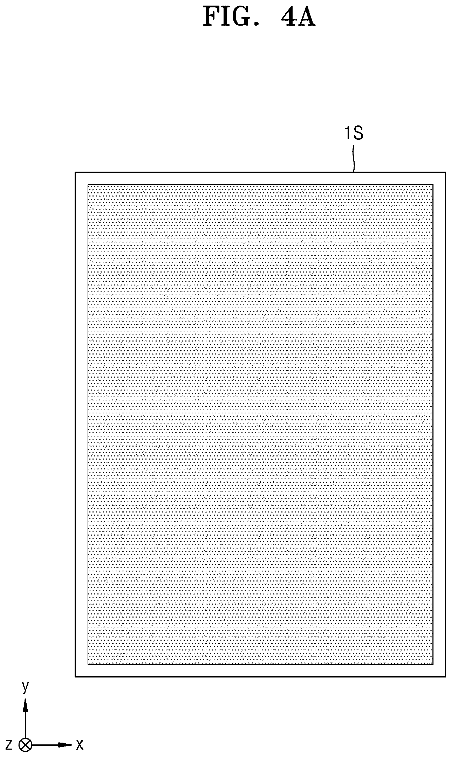

The first semiconductor chip 100L and the second semiconductor chip 100R of the semiconductor device 100 according to the present example embodiment may be manufactured together on the same wafer. The principle of manufacturing the first semiconductor chip 100L and the second semiconductor chip 100R, which are two types forming mirror symmetry, from the same wafer may be based on the feature wherein when forming patterns on a wafer through an exposure process, a plurality of semiconductor chips are arranged to be mirror-symmetrical or origin-symmetrical to each other in 1-shot corresponding to the semiconductor chips. The mirror symmetry or the origin symmetry of the semiconductor chips in the 1-shot is described in detail with reference to FIGS. 4A to 10B.

For reference, the 1-shot may refer to an area of a pattern transferred onto a wafer through a single exposure process using a mask. On the other hand, it may be stated that, in the final structure, the semiconductor chips are mirror-symmetrical or origin-symmetrical to each other within the 1-shot. However, it may be stated that, during the process of manufacturing the semiconductor device, the patterns corresponding to the semiconductor chips are mirror-symmetrical or origin-symmetrical to each other within the 1-shot on a layer where the exposure process is performed.

The semiconductor device 100 according to the present example embodiment may include the first semiconductor chip 100L and the second semiconductor chip 100R of different types. In addition, when the first semiconductor chip 100L and the second semiconductor chip 100R are manufactured on the same wafer and are arranged side-by-side in the x direction, the first semiconductor chip 100L and the second semiconductor chip 100R may have a mirror symmetrical structure with respect to the axis in the y direction. The semiconductor device 100 according to the present example embodiment may maintain symmetry between chips within the 1-shot during the process of manufacturing the semiconductor device, which improves process stability and ensures mass production. For reference, when the semiconductor chips within the 1-shot are asymmetrical, defects, such as mold leaning, a landslip, and a three-dimensional (3D) effect, may occur when forming a structure with a high aspect ratio (A/R). The 3D effect refers to an effect in which a step line is deformed during deep etching. In addition, in the semiconductor device 100 according to the present example embodiment, the extension area is arranged on one side of the cell area, and thus, the effect of chip size reduction (CSR) of 3% or more may be expected, compared to a structure in which extension areas are arranged on both sides of the cell area.

Although a general VNAND has been described as an example, the semiconductor device 100 according to the present example embodiment is not limited to the general VNAND. For example, the semiconductor device 100 according to the present example embodiment may be applied to any type of VNAND including a word line pad or an electrode pad having a stepped structure, such as ON/OP mold VNAND, selective epitaxial growth (SEG)-oriented VNAND, chip on peri (COP) structure VNAND, or BVNAND. For reference, in the ON/OP mold, the ON mold may refer to an oxide/nitride mold and the OP mold may refer to an oxide/polysilicon mold. In addition, the BVNAND is a bonding VNAND having a structure in which two VNANDs are bonded. Moreover, the semiconductor device 100 according to the present example embodiment is not limited to the VNAND and may be applied to any 3D semiconductor chip including an electrode pad having a stepped structure.

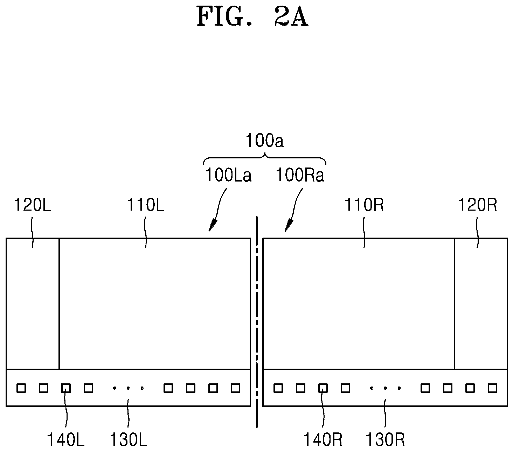

FIGS. 2A to 2E are plan views of semiconductor devices according to some example embodiments. Elements described above with reference to FIGS. 1A and 1B are briefly described or omitted.

Referring to FIG. 2A, a semiconductor device 100a according to an example embodiment may include a first semiconductor chip 100La and a second semiconductor chip 100Ra. The first semiconductor chip 100La and the second semiconductor chip 100Ra may be substantially the same as the first semiconductor chip 100L and the second semiconductor chip 100R of FIG. 1A, respectively. However, the first semiconductor chip 100La may include first chip pads 140L on the front surface of the chip, and the second semiconductor chip 100Ra may include second chip pads 140R on the front surface of the chip. The front surface of a chip may be a surface of the chip parallel to but opposite to a substrate. When a substrate, an integrated circuit, and multiple wiring layers are sequentially arranged in a vertical direction, that is, a z direction, the front surface of the chip refers to the upper surface on which the multiple wiring layers are arranged and may correspond to an active surface. In addition, the chip pads refer to input/output terminals for externally connecting the multiple wiring layers and may be connected to wires or bumps when a semiconductor chip is mounted on a package substrate. The vertical direction may be a direction perpendicular to an upper surface of the substrate. The vertical direction may be perpendicular to the x direction and the y direction. The x direction and the y direction may be horizontal directions. The x direction may be perpendicular to the y direction.

In the semiconductor device 100a according to the present example embodiment, the first semiconductor chip 100La and the second semiconductor chip 100Ra may be mirror-symmetrical to each other with respect to the axis in the y direction, and the first chip pad 140L and the second chip pad 140R may also be mirror-symmetrical to each other with respect to the axis in the y direction. For example, when the first semiconductor chip 100La and the second semiconductor chip 100Ra are arranged adjacent to each other in the x direction and the longer side of each of the first semiconductor chip 100La and the second semiconductor chip 100Ra is arranged in the x direction (e.g. extending in the x-direction), the first chip pads 140L may be disposed in the x direction (e.g. in one or more rows in the x-direction) on the front surface of the chip corresponding to a first peripheral area 130L, and the second chip pads 140R may be disposed in the x direction (e.g. in one or more rows in the x-direction) on the front surface of the chip corresponding to a second peripheral area 130R. The arrangement positions and alignment directions of the first chip pads 140L may be mirror-symmetrical to the arrangement positions and alignments direction of the second chip pads 140R with respect to the axis in the y direction. On the other hand, in FIG. 2A, the first chip pads 140L and the second chip pads 140R are arranged in one row, but the first chip pads 140L and the second chip pads 140R are not limited thereto and may be arranged in two or more rows.

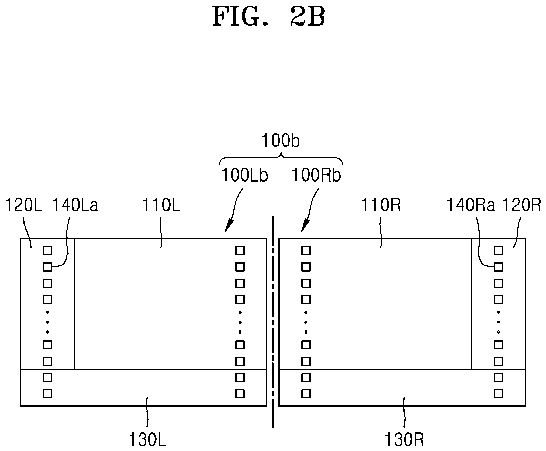

Referring to FIG. 2B, a semiconductor device 100b according to the present example embodiment may differ from the semiconductor device 100a of FIG. 2A in the arrangement positions and alignment directions of chip pads 140La of a first semiconductor chip 100Lb and chip pads 140Ra of a second semiconductor chip 100Rb. For example, the semiconductor device 100b according to the present example embodiment may include the first semiconductor chip 100Lb and the second semiconductor chip 100Rb. In addition, when the first semiconductor chip 100Lb and the second semiconductor chip 100Rb are arranged adjacent to each other in the x direction and the longer side of each of the first semiconductor chip 100Lb and the second semiconductor chip 100Rb is arranged in the x direction (e.g. extending in the x-direction), the first chip pads 140La of the first semiconductor chip 100Lb may be disposed in the y direction (e.g. in one or more columns in the y-direction) on the front surface of the chip at both outer portions thereof in the x direction, and the second chip pads 140Ra of the second semiconductor chip 100Rb may be disposed in the y direction (e.g. in one or more columns in the y-direction) on the front surface of the chip at both outer portions thereof in the x direction. For each semiconductor chip, "outer portions" in the y-direction, may represent portions on opposite sides of the semiconductor chip in the y-direction. The arrangement positions and alignment directions of the first chip pads 140La may be mirror-symmetrical to the arrangement positions and alignments direction of the second chip pads 140Ra with respect to the axis in the y direction. On the other hand, in FIG. 2B, the first chip pads 140La and the second chip pads 140Ra are arranged in one column at both outer portions thereof in the x direction, but the first chip pads 140La and the second chip pads 140Ra are not limited thereto and may be arranged in two or more columns at both outer portions thereof in the x direction. In some example embodiments, the first chip pads 140La and the second chip pads 140Ra may be disposed in the y direction on the front surface of the chip at one outer portion of the chip in the x direction.

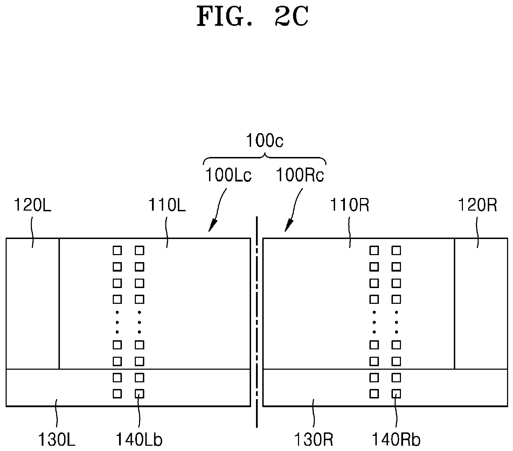

Referring to FIG. 2C, a semiconductor device 100c according to the present example embodiment may differ from the semiconductor device 100a of FIG. 2A in the arrangement positions and alignment directions of chip pads 140Lb of a first semiconductor chip 100Lc and chip pads 140Rb of a second semiconductor chip 100Rc. For example, the semiconductor device 100c according to the present example embodiment may include the first semiconductor chip 100Lc and the second semiconductor chip 100Rc. In addition, when the first semiconductor chip 100Lc and the second semiconductor chip 100Rc are arranged adjacent to each other in the x direction and the longer side of each of the first semiconductor chip 100Lc and the second semiconductor chip 100Rc is arranged in the x direction (e.g. extending in the x-direction), the first chip pads 140Lb of the first semiconductor chip 100Lc may be disposed in the y direction (e.g. in one or more columns in the y-direction) on the front surface of the chip at the central portion thereof in the x direction, and the second chip pads 140Rb of the second semiconductor chip 100Rc may be disposed in the y direction (e.g. in one or more columns in the y-direction) on the front surface of the chip at the central portion thereof in the x direction. The arrangement positions and alignment directions of the first chip pads 140Lb may be mirror-symmetrical to the arrangement positions and alignment directions of the second chip pads 140Rb with respect to the axis in the y direction. On the other hand, in FIG. 2C, the first chip pads 140Lb and the second chip pads 140Rb are arranged in two columns at the central portion thereof in the x direction, but the first chip pads 140Lb and the second chip pads 140Rb are not limited thereto and may be arranged in one or three or more columns at the central portion thereof in the x direction.

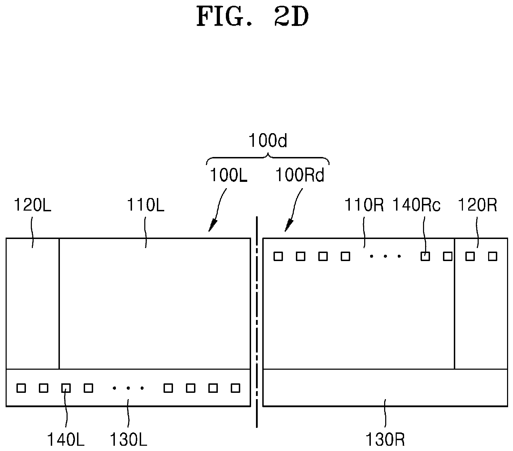

Referring to FIG. 2D, a semiconductor device 100d according to the present example embodiment may differ from the semiconductor devices 100a to 100c of FIGS. 2A to 2C in the arrangement positions and alignment directions of first chip pads 140L of a first semiconductor chip 100L and second chip pads 140Rc of a second semiconductor chip 100Rd. For example, the arrangement structure of cell areas 110L and 110R, extension areas 120L and 120R, and peripheral areas 130L and 130R of the first semiconductor chip 100L and the second semiconductor chip 100Rd in the semiconductor device 100d according to the present example embodiment may be substantially the same as the cell areas 110L and 110R, the extension areas 120L and 120R, and the peripheral areas 130L and 130R of the first semiconductor chip 100L and the second semiconductor chip 100R in the semiconductor device 100 of FIG. 1A. However, the first chip pads 140L of the first semiconductor chip 100L and the second chip pads 140Rc of the second semiconductor chip 100Rd may have different arrangement positions and may not be mirror-symmetrical to each other with respect to the axis in the y direction. For example, in the semiconductor device 100d according to the present example embodiment, when the first semiconductor chip 100L and the second semiconductor chip 100Rd are arranged adjacent to each other in the x direction and the longer side of each of the first semiconductor chip 100L and the second semiconductor chip 100Rd is arranged in the x direction (e.g. extending in the x-direction), the first chip pads 140L may be disposed in the x direction (e.g. in one or more rows in the x-direction) on the front surface of the chip corresponding to the first peripheral area 130L, and the second chip pads 140Rc may be disposed in the x direction (e.g. in one or more rows in the x-direction) on the front surface of the chip corresponding to the opposite side of the second semiconductor chip 100Rd to the second peripheral area 130R in the y direction. Accordingly, the arrangement positions of the first chip pads 140L may not be mirror-symmetrical to the arrangement positions of the second chip pads 140Rc with respect to the axis in the y direction. On the other hand, in FIG. 2D, the first chip pads 140L and the second chip pads 140Rc are arranged in one row, but the first chip pads 140L and the second chip pads 140Rc are not limited thereto and may be arranged in two or more rows.

In the semiconductor device 100d according to the present example embodiment, when forming the chip pads of the semiconductor chips and the wirings connected thereto on the wafer through the exposure process, the patterns of the semiconductor chips within 1-shot corresponding thereto are configured not to be mirror-symmetrical to each other. In this manner, the mirror asymmetric structure of the first chip pads 140L of the first semiconductor chip 100L and the second chip pads 140Rc of the second semiconductor chip 100Rd may be implemented. In other words, before forming the chip pads and the wirings, all corresponding patterns of the semiconductor chips within the 1-shot may be configured to be mirror-symmetrical to each other, and the patterns of the semiconductor chips within the 1-shot corresponding to the chip pads and the wirings may be configured not to be mirror-symmetrical to each other. As such, in the semiconductor device 100d according to the present example embodiment, the first chip pads 140L of the first semiconductor chip 100L and the second chip pads 140Rc of the second semiconductor chip 100Rd are formed so as not to be mirror-symmetrical to each other with respect to the axis in the y direction. Accordingly, when mounting the first semiconductor chip 100L and the second semiconductor chip 100Rd on a package substrate, the connection structure with wires or bumps may be configured more freely and diversely. Thus, the degree of freedom of the mounting structure of the semiconductor chips on the package substrate in the semiconductor package and the wiring structure within the package substrate may be significantly improved.

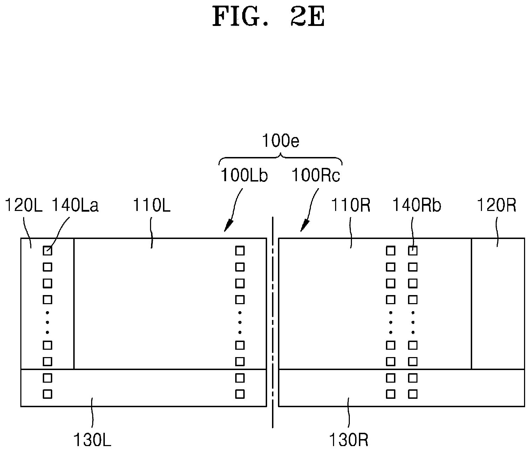

Referring to FIG. 2E, a semiconductor device 100e according to the present example embodiment may differ from the semiconductor device 100d of FIG. 2D in the arrangement positions of first chip pads 140La of a first semiconductor chip 100Lb and second chip pads 140Rb of a second semiconductor chip 100Rc. For example, the semiconductor device 100e according to the present example embodiment may include the first semiconductor chip 100Lb and the second semiconductor chip 100Rc. In addition, when the first semiconductor chip 100Lb and the second semiconductor chip 100Rc are arranged adjacent to each other in the x direction and the long side of each of the first semiconductor chip 100Lb and the second semiconductor chip 100Rc is arranged in the x direction (e.g. extending in the x-direction), the first chip pads 140La of the first semiconductor chip 100Lb may be disposed in the y direction (e.g. in one or more columns in the y-direction) on the front surface of the chip at both outer portions thereof in the x direction, and the second chip pads 140Rb of the second semiconductor chip 100Rc may be disposed in the y direction (e.g. in one or more columns in the y-direction) on the front surface of the chip at the central portion thereof in the x direction. Accordingly, the arrangement positions of the first chip pads 140La may not be mirror-symmetrical to the arrangement positions of the second chip pads 140Rb with respect to the axis in the y direction. On the other hand, in FIG. 2E, the first chip pads 140La are arranged in one row at both outer portions thereof in the x direction and the second chip pads 140Rb are arranged in two rows at the center portion in the x direction, but the number of rows of the first chip pads 140La and the second chip pads 140Rb is not limited thereto.

In the semiconductor devices 100d and 100e of FIGS. 2D and 2E, two structures in which the chip pads are not mirror-symmetrical to each other with respect to the axis in the y direction have been described, but the structure of the chip pads of semiconductor devices according to inventive concepts are not limited thereto. For example, the chip pads may be arranged in various structures other than mirror symmetry with respect to the axis in the y direction, in addition to the two structures described above.

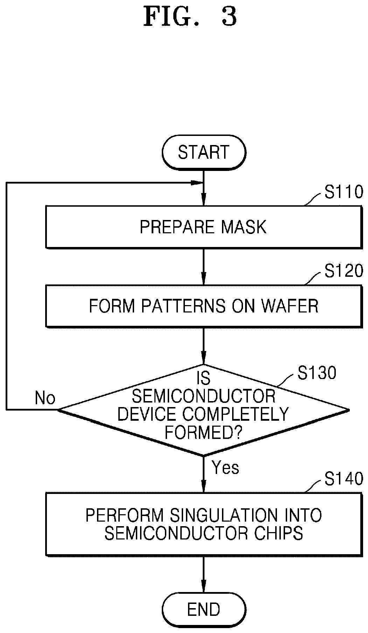

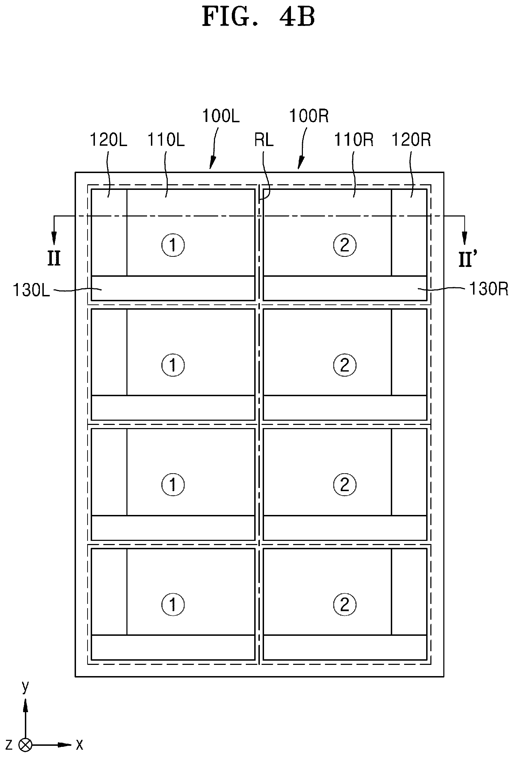

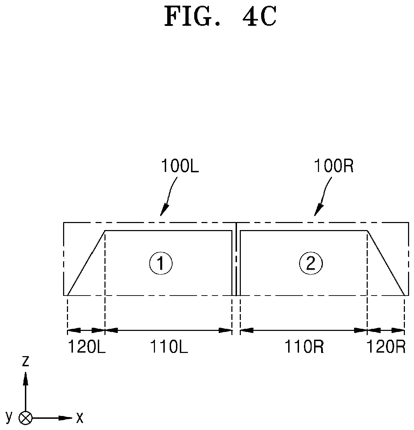

FIG. 3 is a flowchart schematically illustrating a method of manufacturing a semiconductor device, according to an example embodiment, FIGS. 4A to 4C are respectively plan views and a cross-sectional view for describing the concept of 1-shot of mirror symmetry in the method of manufacturing the semiconductor device illustrated in FIG. 3. FIG. 4C is a cross-sectional view taken along line II-II' of FIG. 4B. The following description is given with reference to FIGS. 1A and 1B together, and elements provided above with reference to FIGS. 1A to 2E are briefly described or omitted.

Referring to FIGS. 3 and 4A to 4C, in the method of manufacturing the semiconductor device according to the present example embodiment, a mask may be prepared (S110). In a semiconductor process, an exposure process using a mask may be performed so as to form patterns in semiconductor chips on a wafer. The mask may be simply defined as a pattern transfer body in which a pattern shape of an opaque material is formed on a transparent base material. The process of preparing or manufacturing the mask may include a layout design for patterns, optical proximity correction (OPC), mask tape-out (MTO), mask data preparation (MDP), E-beam exposure, etc.

After the mask is prepared, patterns may be formed on the wafer through an exposure process using the mask (S120). That is, the same patterns may be formed on the semiconductor chips within the wafer through the exposure process using the mask. For example, the pattern or the area of the pattern transferred onto the wafer through a single exposure process using the mask is referred to as 1-shot. Patterns corresponding to the semiconductor chips may be included within the 1-shot. In addition, patterns may be formed on the entire wafer by performing a plurality of exposure processes corresponding to a plurality of shots in the x direction and the y direction.

FIG. 4A is a plan view of 1-shot 1S and an actual pattern may be formed at the central hatched portion. For reference, an outer peripheral portion is a portion that overlaps adjacent shots. In some example embodiments, alignment marks, etc. may be arranged in the outer peripheral portion. FIG. 4B illustrates patterns included in 1-shot with the concept of a semiconductor chip. In other words, the 1-shot may include a plurality of patterns corresponding to a plurality of semiconductor chips. Hereinafter, for convenience of explanation, one pattern is described with the concept of one semiconductor chip.

In the method of manufacturing the semiconductor device according to the present example embodiment, a plurality of semiconductor chips may be included in the 1-shot. In addition, in the 1-shot, two semiconductor chips may be arranged adjacent to each other in the x direction and two or more (e.g., four) semiconductor chips may be arranged in the y direction. That is, two columns of four semiconductor chips (or four rows of two semiconductor chips) may be included in the 1-shot. In FIG. 4B, semiconductor chips indicated by ① may correspond to a first semiconductor chip 100L and semiconductor chips indicated by 02 may correspond to a second semiconductor chip 100R. Accordingly, in each of the semiconductor chips indicated by ①, as described above for the first semiconductor chip 100L, a first extension area 120L may be arranged on the left side of a first cell area 110L in the x direction and a first peripheral area 130L may be disposed below the first cell area 110L in the y direction. Accordingly, in each of the semiconductor chips indicated by ①, as described above for the second semiconductor chip 100R, a second extension area 120R may be arranged on the right side of a second cell area 110R in the x direction and a second peripheral area 130R may be disposed below the second cell area 110R in the y direction.

In the method of manufacturing the semiconductor device according to the present example embodiment, the semiconductor chips indicated by ① and the semiconductor chips indicated by ② included in the 1-shot may be mirror-symmetrical to each other with respect to a reference line RL, that is, the axis in the y direction. For example, the patterns corresponding to the semiconductor chips, which are formed in the exposure process on the corresponding layer, may be mirror-symmetrical to each other with respect to the reference line RL. The mirror symmetry is the same as described with reference to FIGS. 1A and 1B. In addition, because the extension area having the stepped structure is not formed in the initial semiconductor device, the cross-sectional view of FIG. 4C may correspond to the cross-sectional view of the semiconductor device after the extension area having the stepped structure is formed.

On the other hand, in some example embodiments, in the forming of the patterns on the wafer (S120), the structure in which the semiconductor chips within the 1-shot are mirror-symmetrical to each other with respect to the reference line RL may not be established for the chip pads and the wirings connected to the chip pads. For example, as in the descriptions of the semiconductor devices 100d and 100e of FIGS. 2D and 2E, the patterns within the 1-shot corresponding to the first chip pads 140L and 140La of the first semiconductor chips 100L and 100Lb may not be mirror-symmetrical to the patterns within the 1-shot corresponding to the second chip pads 140Rc and 140Rb of the second semiconductor chips 100Rd and 100Rc.

After the patterns are formed on the wafer, it may be determined whether the semiconductor device is completely formed (S130). For example, in order to completely form the semiconductor device, patterns may be formed in tens to hundreds of layers and the pattern of each of the layers may be formed by using a corresponding mask. In addition, because at least one mask may be used to form the pattern of one layer, a much larger number of masks than the number of layers may be desired so as to form the patterns of all layers.

When the semiconductor device has not been completely formed (No), the process may proceed to operation S 110 of preparing the mask, a mask corresponding to a next pattern may be prepared, and the subsequent operations may be performed again.

When the semiconductor device has been completely formed (Yes), the wafer is singulated (e.g. separated or cut) into a plurality of semiconductor chips (S140). The singulating of the wafer may be performed through a sawing process. In FIG. 4B, a narrow area between adjacent semiconductor chips may correspond to a scribe lane area. The sawing process may be carried out by performing a cutting process on the scribe lane area by using a blade or a laser.

The semiconductor device 100 of FIG. 1A may be completely formed through the singulation into the semiconductor chips. The semiconductor device 100 may include the first semiconductor chip 100L corresponding to ① and the second semiconductor chip 100R corresponding to ②. On the other hand, when the semiconductor chips on the wafer corresponding to all shots are completely formed as semiconductor devices, the semiconductor chips manufactured on one wafer may include the same number of first semiconductor chips 100L and second semiconductor chips 100R.

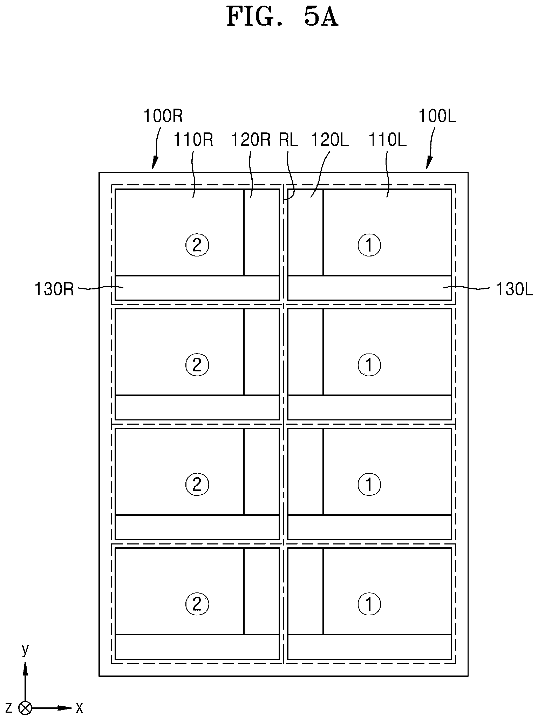

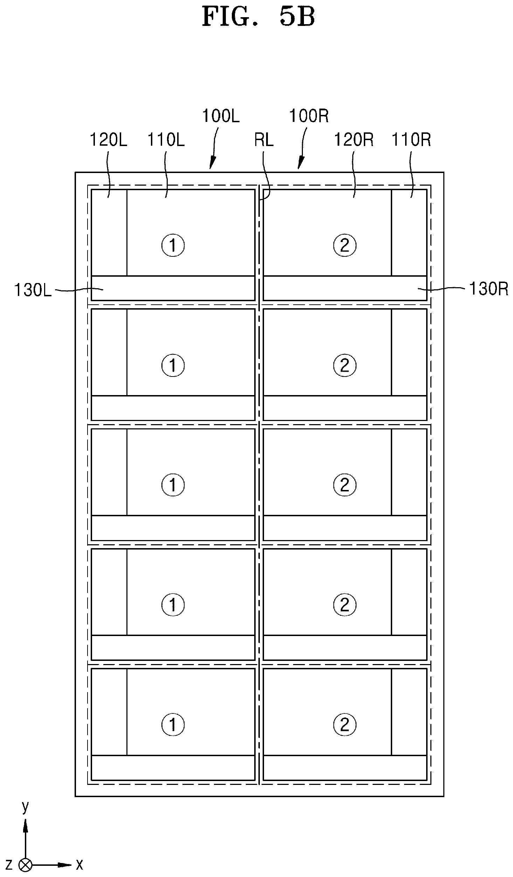

FIGS. 5A and 5B are plan views illustrating other forms of 1-shot of mirror symmetry.

Referring to FIG. 5A, in the method of manufacturing the semiconductor device according to the present example embodiment, semiconductor chips within 1-shot may be mirror-symmetrical to each other with respect to a reference line RL but may be mirror-symmetrical to each other differently from those in FIG. 4B. For example, in the 1-shot, first semiconductor chips 100L indicated by ① may be arranged on the right side in the x direction and second semiconductor chips 100R indicated by ② may be arranged on the left side in the x direction. As described above, in the first semiconductor chip 100L, a first extension area 120L may be arranged on the left side of a first cell area 110L in the x direction, and a first peripheral area 130L may be disposed below the first cell area 110L in the y direction. In addition, in the second semiconductor chip 100R, a second extension area 120R may be arranged on the right side of a second cell area 110R in the x direction, and a second peripheral area 130R may be disposed below the second cell area 110R in the y direction.

Even in the method of manufacturing the semiconductor device according to the present example embodiment, the first semiconductor chip 100L and the second semiconductor chip 100R may be mirror-symmetrical to each other with respect to the reference line RL within the 1-shot. The first cell area 110L and the second cell area 110R are adjacent to each other in the x direction within the 1-shot of FIG. 4B. That is, in the embodiment of FIG. 4B, the extension regions are located on an opposite side of the semiconductor chips to the reference line RL (the axis of symmetry). However, in the method of manufacturing the semiconductor device according to the present example embodiment, because the positions of the first semiconductor chip 100L and the second semiconductor chip 100R within the 1-shot are changed with each other, the first extension area 120L and the second extension area 120R may be adjacent to each other in the x-direction within the 1-shot of FIG. 5A.

Referring to FIG. 5B, in the method of manufacturing the semiconductor device according to the present example embodiment, the number of semiconductor chips within the 1-shot may be different from the number of semiconductor chips within the 1-shot in FIG. 4B. For example, five first semiconductor chips 100L and five second semiconductor chips 100R may be arranged in the y direction within the 1-shot. However, the number of semiconductor chips arranged within the 1-shot is not limited thereto. For example, two or more semiconductor chips may be arranged in the y direction within the 1-shot and the number of semiconductor chips may not be limited to even or odd numbers. However, based on mirror symmetry with respect to the reference line RL, two first semiconductor chips 100L and two second semiconductor chips 100R may be arranged in the x direction within the 1-shot. However, in some example embodiments, four or more first semiconductor chips 100L and four or more second semiconductor chips 100R may be arranged in pairs in the x direction within the 1-shot.

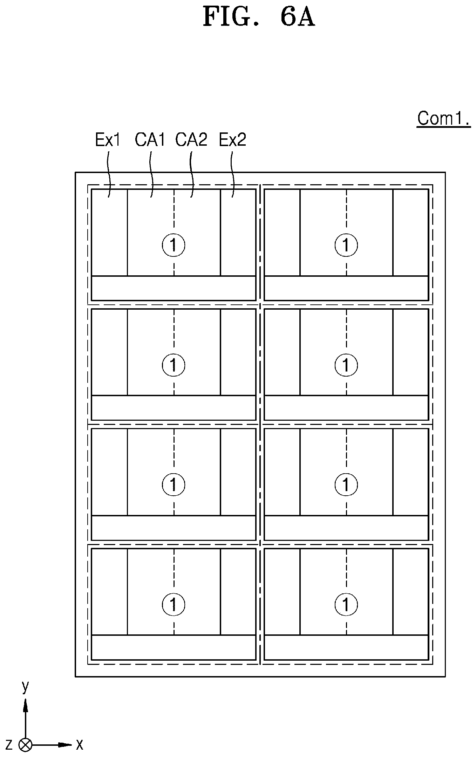

FIGS. 6A to 6D are respectively plan views and cross-sectional views illustrating the form of 1-shot according to comparative examples.

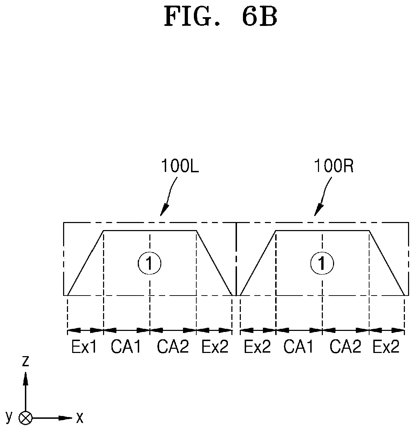

Referring to FIGS. 6A and 6B, in the case of a first comparative example (Com1.), all semiconductor chips within the 1-shot may have the same structure, a cell area in each of the semiconductor chips may be divided into two cell areas CA1 and CA2, and extension areas EX1 and EX2 may be arranged on both sides of the cell area in the x direction. The 1-shot of the first comparative example (Com1.) may be disadvantageous in terms of chip size reduction (CSR) implementation of the chip because the two extension areas EX1 and EX2 are arranged in one semiconductor chip.

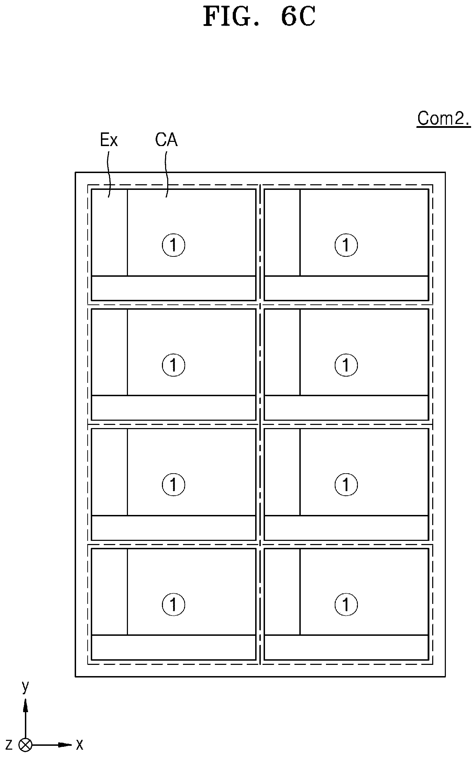

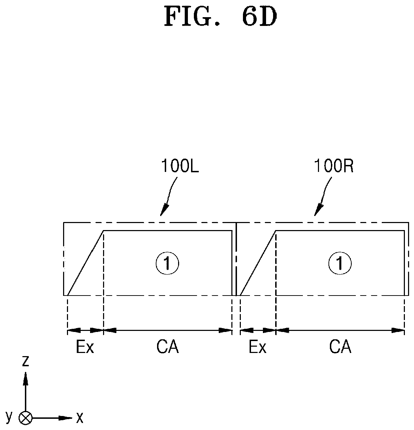

Referring to FIGS. 6C and 6D, in the case of a second comparative example (Com2.), all semiconductor chips within the 1-shot may have the same structure and one extension area EX may be arranged on the same side (e.g. the left side) of a cell area CA in each of the semiconductor chips. However, in terms of the entire 1-shot, the semiconductor chips have an asymmetric structure, which may cause problems during a manufacturing process. For example, in the case of a VNAND, defects, such as mold leaning, a landslip, and a 3D effect, may occur due to mold asymmetry and warpage may also occur.

In contrast, in the method of manufacturing the semiconductor device according to the present example embodiment, two types of semiconductor chips are arranged to be mirror-symmetrical within the 1-shot, and thus, the problems caused by the asymmetric structure of the second comparative example (Com2.) may be solved. In addition, because one extension area is arranged in one semiconductor chip, chip size is reduced compared to the first comparative example (Com1.).

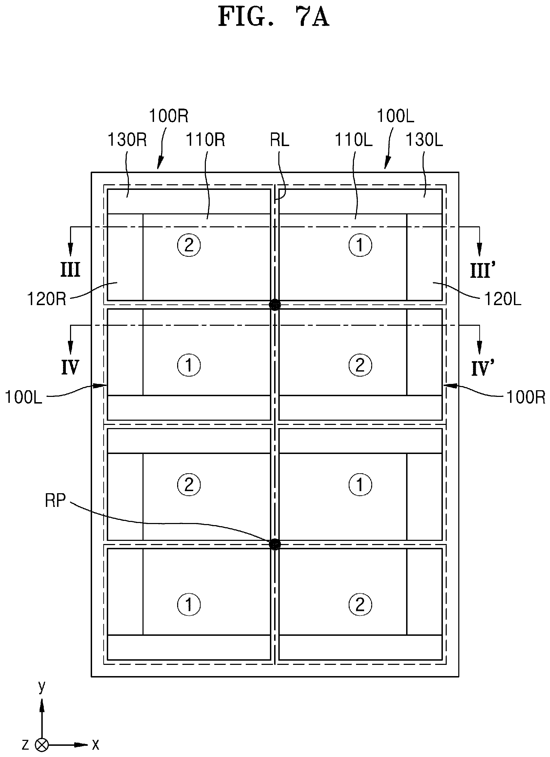

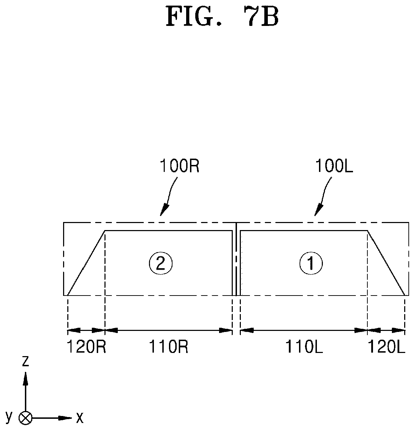

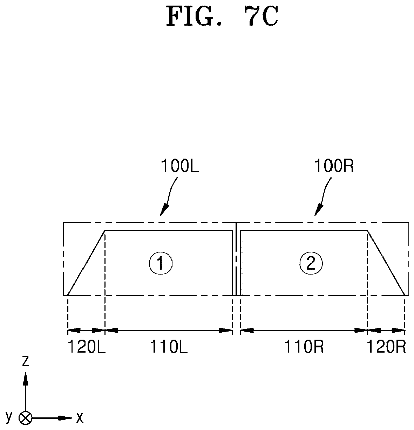

FIGS. 7A to 7C are respectively a plan view and cross-sectional views for describing the concept of 1-shot of origin symmetry in the method of manufacturing the semiconductor device illustrated in FIG. 3. FIGS. 7B and 7C are cross-sectional views taken along lines III-III' and IV-IV' of FIG. 7A, respectively. Elements described above with reference to FIGS. 1A to 6B are briefly described or omitted.

Referring to FIGS. 7A to 7C, in the method of manufacturing the semiconductor device according to the present example embodiment, a plurality of semiconductor chips may be included in 1-shot. In addition, in the 1-shot, two semiconductor chips may be arranged adjacent to each other in the x direction and two or more (e.g., four) semiconductor chips may be arranged in the y direction. In FIG. 7A, semiconductor chips indicated by ① may correspond to first semiconductor chips 100L and semiconductor chips indicated by 02 may correspond to second semiconductor chips 100R.

In FIG. 7A, in each of the first semiconductor chips 100L indicated by ① and arranged on the left side in the x direction, a first extension area 120L may be arranged on the left side of a first cell area 110L in the x direction, and a first peripheral area 130L may be disposed below the first cell area 110L in the y direction. In addition, in each of the first semiconductor chips 100L indicated by ① and arranged on the right side in the x direction, a first extension area 120L may be arranged on the right side of a first cell area 110L in the x direction, and a first peripheral area 130L may be disposed above the first cell area 110L in the y direction. Accordingly, the first semiconductor chip 100L arranged on the left side in the x direction and the first semiconductor chip 100L arranged on the right side in the x direction may have a 180° rotation relationship. That is, the first semiconductor chip(s) 100L arranged on the right side in the x direction may be equivalent to the first semiconductor chip(s) 100L arranged on the left side when rotated by 180°.

In addition, in each of the second semiconductor chips 100R indicated by ② and arranged on the right side in the x direction, a second extension area 120R may be arranged on the right side of a second cell area 110R in the x direction, and a second peripheral area 130R may be disposed below the second cell area 110R in the y direction. In addition, in each of the second semiconductor chips 100R indicated by ② and arranged on the left side in the x direction, a second extension area 120R may be arranged on the left side of a first cell area 110R in the x direction, and a second peripheral area 130R may be disposed above the second cell area 110R in the y direction. Accordingly, the second semiconductor chip 100R arranged on the left side in the x direction and the second semiconductor chip 100R arranged on the right side in the x direction may have a 180° rotation relationship. That is, the second semiconductor chip(s) 100R arranged on the right side in the x direction may be equivalent to the second semiconductor chip(s) 100R arranged on the left side when rotated by 180°.

In the method of manufacturing the semiconductor device according to the present example embodiment, the first semiconductor chip 100L and the second semiconductor chip 100R included in the 1-shot may be mirror-symmetrical to each other with respect to the reference line RL, that is, the axis in the y direction. In addition, the first semiconductor chips 100L and the second semiconductor chips 100R may be alternately arranged in the y direction within the 1-shot. As such, because the first semiconductor chips 100L and the second semiconductor chips 100R are mirror-symmetrical to each other with respect to the reference line RL in the x direction and are alternately arranged in the y direction, four semiconductor chips 100L and 100R adjacent to each other in the x direction and the y directions may be origin-symmetrical to each other with respect to a reference point RP, that is, the origin. The reference point RP (the origin) may be located at the center between four adjacent semiconductor chips. In addition, due to this origin symmetry, adjacent first semiconductor chips 100L and second semiconductor chips 100R may be symmetrical about a further reference line, that is, the axis in the x direction (e.g. located between the first and second semiconductor chips 100L and 100R).

For example, as illustrated in FIG. 7A, when four semiconductor chips are arranged in four quadrants within the 1-shot, two first semiconductor chips 100L may be arranged in the first and third quadrants and two second semiconductor chips 100R may be arranged in the second and fourth quadrants. Accordingly, the two first semiconductor chips 100L may be origin-symmetrical to each other with respect to the reference point RP and the two second semiconductor chips 100R may be origin-symmetrical to each other with respect to the reference point RP. In addition, the second semiconductor chip 100R and the first semiconductor chip 100L arranged on the left side in the x direction may be mirror-symmetrical to the first semiconductor chip 100L and the second semiconductor chip 100R arranged on the right side in the x direction with respect to the reference line RL and may be origin-symmetrical thereto with respect to the reference point RP. In the arrangement discussed herein, the four quadrants may be labelled such that the bottom left quadrant is the first, the top right quadrant is the second, the top left quadrant is the third and the bottom right quadrant is the fourth. Having said this, due to the origin symmetry described herein, the labelling of the quadrants may be varied.

On the other hand, as illustrated in FIG. 7A, eight semiconductor chips may be included in the 1-shot. Accordingly, the four semiconductor chips on the upper side may be origin-symmetrical to each other with respect to a reference point RP for the upper four semiconductor chips, and the four semiconductor chips on the lower side may be origin-symmetrical to each other with respect to a reference point RP for the lower four semiconductor chips. That is, each group of four semiconductor chips may have a corresponding reference point located at the center. In the method of manufacturing the semiconductor device according to the present example embodiment, the even numbers of first semiconductor chips 100L and second semiconductor chips 100R may be alternately arranged in the y direction within the 1-shot. In other words, in order to configure origin symmetry, the odd numbers of first semiconductor chips 100L and second semiconductor chips 100R are not arranged in the y direction. On the other hand, based on mirror symmetry with respect to the reference line RL, first semiconductor chips 100L and second semiconductor chips 100R may be arranged in the x direction within the 1-shot. However, in some example embodiments, two or more first semiconductor chips 100L and two or more second semiconductor chips 100R may be arranged in pairs in the x direction within the 1-shot.

In addition, because the extension area having the stepped structure is not formed in the initial semiconductor device, the cross-sectional views of FIGS. 7B and 7C may correspond to the cross-sectional view of the semiconductor device after the extension area having the stepped structure is formed. In addition, in some example embodiments, in the forming of the patterns on the wafer (S 120), the structure in which the semiconductor chips within the 1-shot are mirror-symmetrical to each other with respect to the reference line RL and are origin-symmetrical to each other with respect to the reference point RP may not be established for the chip pads and the wirings connected to the chip pads.

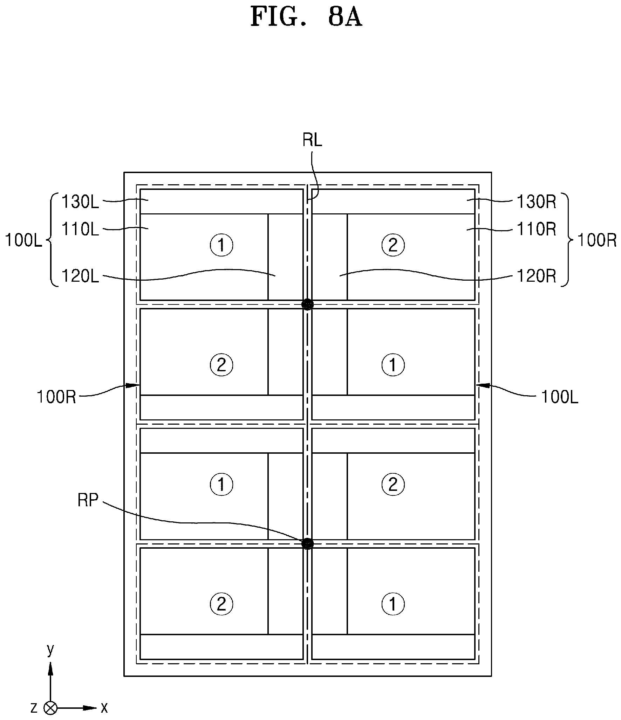

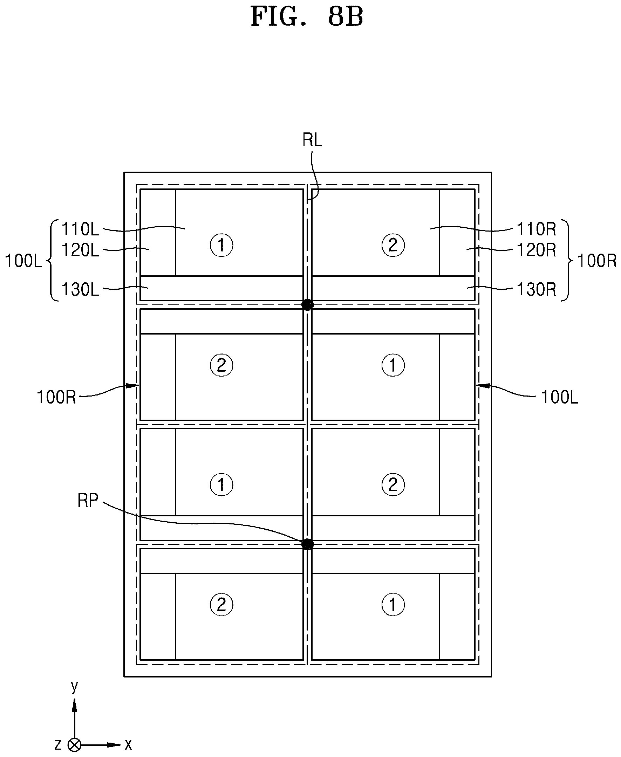

FIGS. 8A and 8B are plan views illustrating other forms of 1-shot of origin symmetry.

Referring to FIG. 8A, in the method of manufacturing the semiconductor device according to the present example embodiment, four semiconductor chips may be origin-symmetrical to each other with respect to a reference point RP within 1-shot but may be origin-symmetrical to each other differently from those in FIG. 7A. For example, as illustrated in FIG. 8A, when four semiconductor chips are arranged in four quadrants within the 1-shot, two first semiconductor chips 100L may be arranged in the second and fourth quadrants and two second semiconductor chips 100R may be arranged in the first and third quadrants. Accordingly, the two first semiconductor chips 100L may be origin-symmetrical to each other with respect to the reference point RP and the two second semiconductor chips 100R may be origin-symmetrical to each other with respect to the reference point RP. In addition, the first semiconductor chip 100L and the second semiconductor chip 100R arranged on the left side in the x direction may be mirror-symmetrical to the second semiconductor chip 100R and the first semiconductor chip 100L arranged on the right side in the x direction with respect to the reference line RL, and may be origin-symmetrical to the first semiconductor chip 100L and the second semiconductor chip 100R arranged on the right side in the x direction with respect to the reference point RP.

On the other hand, compared to FIG. 7A, the positions of the first semiconductor chip 100L and the second semiconductor chip 100R may be changed with each other in the x direction within the 1-shot. Accordingly, a first cell area 110L and a second cell area 110R may be adjacent to each other in the x direction within the 1-shot of FIG. 7A, and a first extension area 120L and a second extension area 120R may be adjacent to each other in the x direction within the 1-shot of FIG. 8A. In addition, the first semiconductor chip 100L arranged on the left side in the x direction and the first semiconductor chip 100L arranged on the right side in the x direction may have a 180° rotation relationship. In addition, the second semiconductor chip 100R arranged on the left side in the x direction and the second semiconductor chip 100R arranged on the right side in the x direction may have a 180° rotation relationship.

Referring to FIG. 8B, in the method of manufacturing the semiconductor device according to the present example embodiment, four semiconductor chips may be origin-symmetrical to each other with respect to a reference point RP within 1-shot but may be origin-symmetrical thereto differently from those in FIG. 8A. For example, as illustrated in FIG. 8B, when four semiconductor chips are arranged in four quadrants within the 1-shot, two first semiconductor chips 100L may be arranged in the second and fourth quadrants and two second semiconductor chips 100R may be arranged in the first and third quadrants. Accordingly, the two first semiconductor chips 100L may be origin-symmetrical to each other with respect to the reference point RP and the two second semiconductor chips 100R may be origin-symmetrical to each other with respect to the reference point RP. In addition, the first semiconductor chip 100L and the second semiconductor chip 100R arranged on the left side in the x direction may be mirror-symmetrical to the second semiconductor chip 100R and the first semiconductor chip 100L arranged on the right side in the x direction with respect to the reference line RL and may be origin-symmetrical to the first semiconductor chip 100L and the second semiconductor chip 100R arranged on the right side in the x direction with respect to the reference point RP.

In the 1-shot structure of FIG. 8B, the structures of the first semiconductor chips 100L in the second and fourth quadrants may not be the same as the 1-shot structure of FIG. 8A. In addition, in the 1-shot structure of FIG. 8B, the structures of the second semiconductor chips 100R in the first and third quadrants may not be the same as the 1-shot structure of FIG. 8A.

For example, the 1-shot of FIG. 8A may have a structure in which the first semiconductor chip 100L in the second quadrant has a first extension area 120L arranged on the right side of the first cell area 110L in the x direction and a first peripheral area 130L disposed above the first cell area 110L in the y direction. On the other hand, the 1-shot of FIG. 8B may have a structure in which the first semiconductor chip 100L in the second quadrant has a first extension area 120L arranged on the left side of the first cell area 110L in the x direction and a first peripheral area 130L disposed below the first cell area 110L in the y direction. On the other hand, in each of the 1-shots of FIG. 8A and FIG. 8B, the 180° rotation relationship between the first semiconductor chip 100L in the second quadrant and the first semiconductor chip 100L in the fourth quadrant may be maintained as it is.

In addition, the 1-shot of FIG. 8A may have a structure in which the second semiconductor chip 100R in the first quadrant has a second extension area 120R arranged on the left side of the second cell area 110R in the x direction and a second peripheral area 130R disposed above the second cell area 110R in the y direction. On the other hand, the 1-shot of FIG. 8B may have a structure in which the second semiconductor chip 100R in the first quadrant has a second extension area 120R arranged on the right side of the second cell area 110R in the x direction and a second peripheral area 130R disposed below the second cell area 110R in the y direction. On the other hand, in each of the 1-shots of FIG. 8A and FIG. 8B, the 180° rotation relationship between the second semiconductor chip 100R in the first quadrant and the second semiconductor chip 100R in the third quadrant may be maintained as it is.

Although not illustrated, for the 1-shot structure of FIG. 7A, the 1-shot structure in which the positions of the first semiconductor chips 100L in the first and third quadrants are changed with each other and the positions of the second semiconductor chips 100R in the second and fourth quadrants are changed with each other may be origin-symmetrical with respect to the reference point RP.

In addition, in the method of manufacturing the semiconductor device according to the present example embodiment, various 1-shot structures that are mirror-symmetrical with respect to the reference line RL even though not being origin-symmetrical may be applied to an exposure process for forming patterns on the wafer. For example, the 1-shot structures may be implemented by arranging unit couple-chips including the first semiconductor chip 100L and the second semiconductor chip 100R, which are mirror-symmetrical to each other with respect to the reference line RL, in various combinations in the y direction. The unit couple-chip may include four types of structures, for example, the structure of FIG. 4B, the structure of FIG. 5A, and the 180° rotation structures thereof.

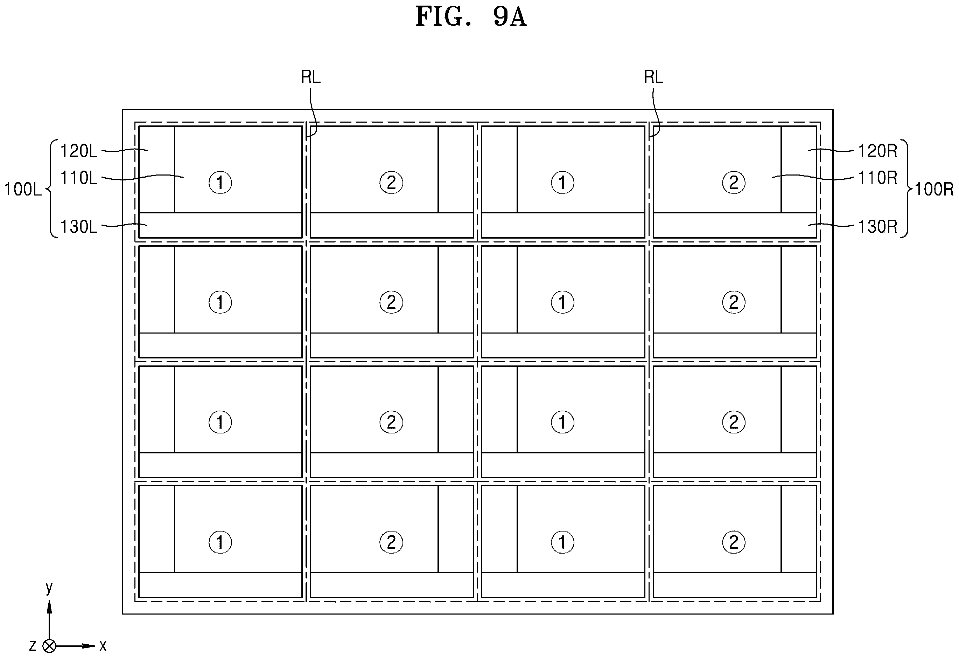

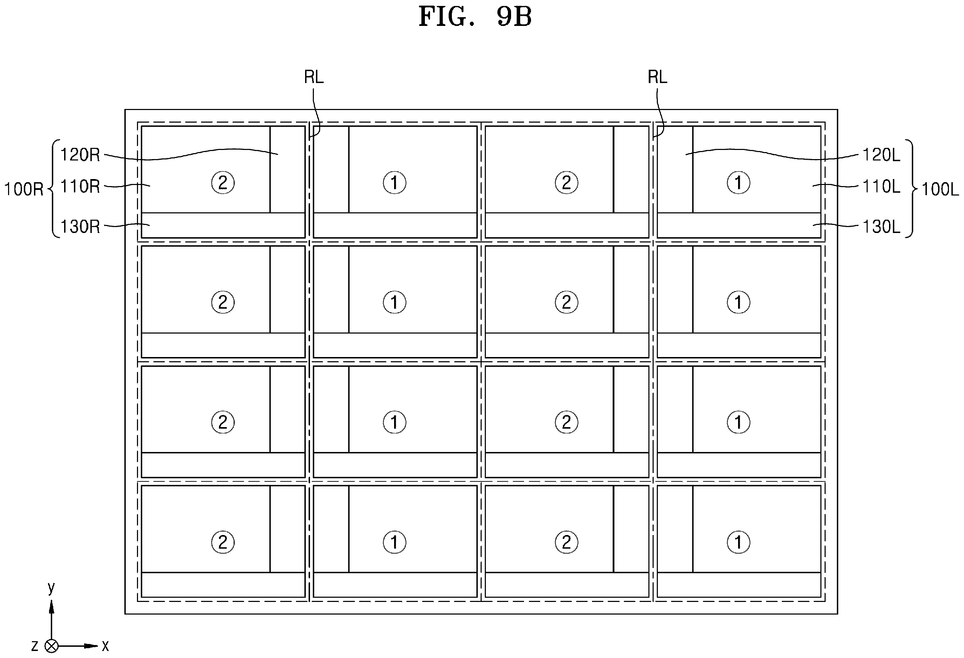

FIGS. 9A and 9B are plan views illustrating two 1-shots of mirror symmetry arranged adjacent to each other.

FIGS. 9A and 9B illustrate structures in which two shots are arranged adjacent to each other in the x direction. In other words, FIG. 9A illustrates a structure in which two 1-shots of FIG. 4B are arranged adjacent to each other in the x direction, and FIG. 9B illustrates a structure in which two 1-shots of FIG. 5A are arranged adjacent to each other in the x direction. On the other hand, as described above, because the 1-shot is the area of the pattern transferred in a single exposure process using a mask, the two shot structures illustrated in FIG. 9A or FIG. 9B may not correspond to a structure in which two shots are transferred onto the wafer at once but may correspond to a structure in which one shot is repeatedly transferred while moving in the x direction.

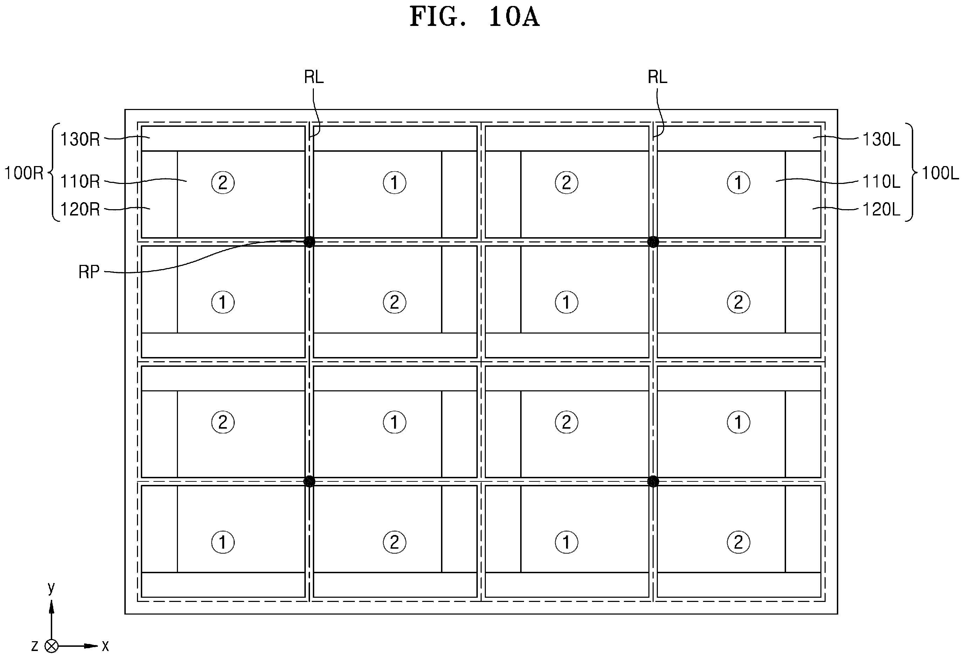

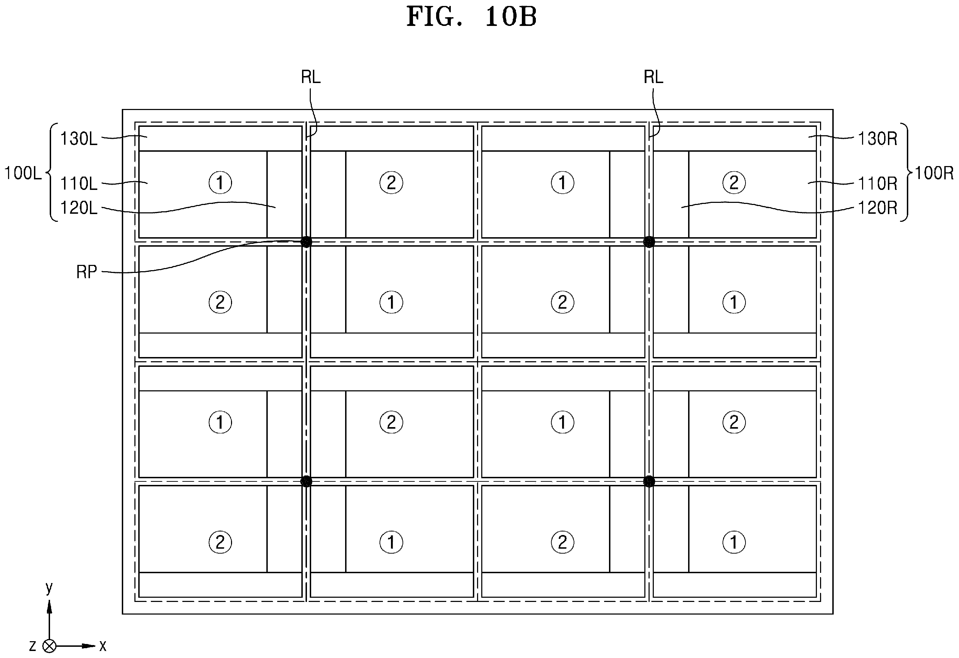

FIGS. 10A and 10B are plan views illustrating two 1-shots of origin symmetry arranged adjacent to each other.

FIGS. 10A and 10B illustrate structures in which two shots are arranged adjacent to each other in the x direction. In other words, FIG. 10A illustrates a structure in which two 1-shots of FIG. 7A are arranged adjacent to each other in the x direction and FIG. 10B illustrates a structure in which two 1-shots of FIG. 8A are arranged adjacent to each other in the x direction. In addition, the two shot structures illustrated in FIGS. 10A and 10B may not correspond to a structure in which two shots are transferred onto the wafer at once but may correspond to a structure in which one shot is repeatedly transferred while moving in the x direction.

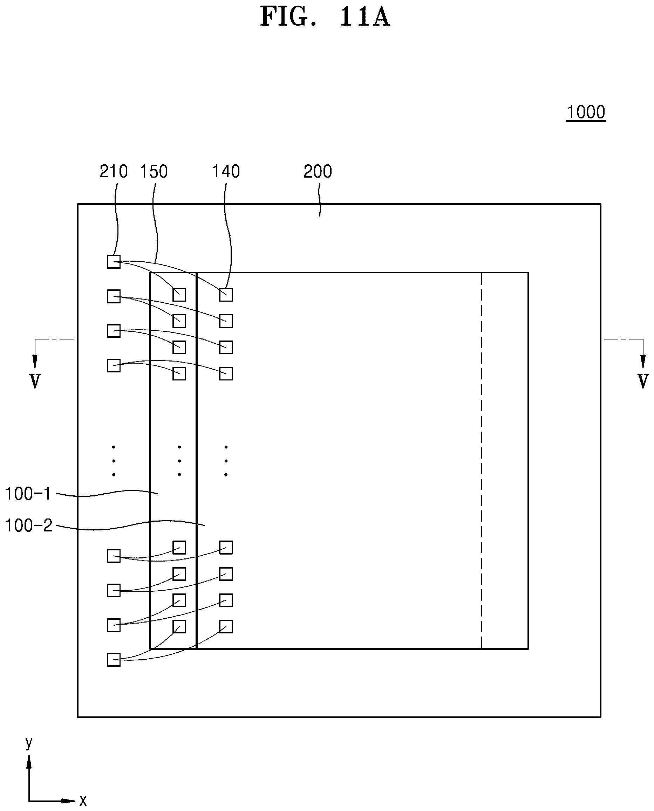

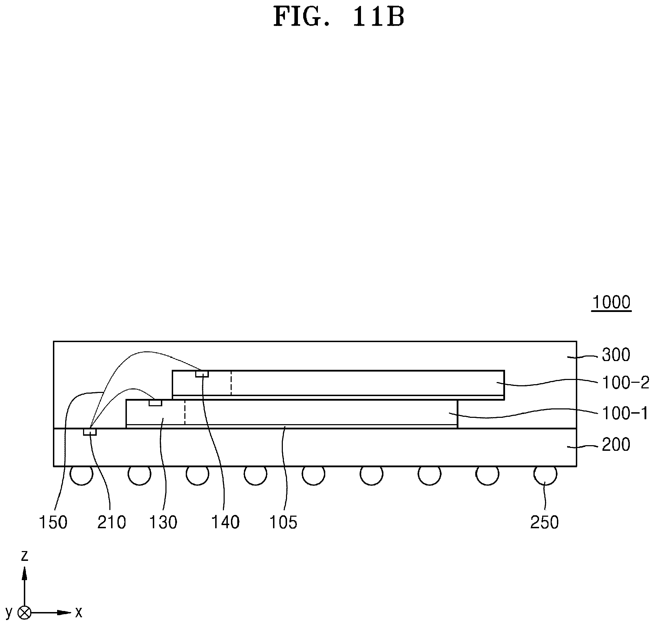

FIGS. 11A and 11B are respectively a plan view and a cross-sectional view of a semiconductor package including a semiconductor device, according to an example embodiment. FIG. 11B is a cross-sectional view taken along line V-V' of FIG. 11A. The following description is given with reference to FIGS. 1A and 1B together, and elements provided above with reference to FIGS. 1A to 10B are briefly described or omitted.

Referring to FIGS. 11A and 11B, a semiconductor package 1000 according to the present example embodiment may include a package substrate 200, semiconductor chips 100-1 and 100-2, and a sealant 300.

The package substrate 200 may be, for example, a printed circuit board (PCB). External connection terminals 250 may be disposed on the lower surface of the package substrate 200. The package substrate 200 may include a body layer, multiple wiring layers, and a protective layer. The body layer may include, for example, resin and glass fiber such as FR4. However, the material of the body layer is not limited thereto. For example, the body layer may include bismaleimide-triazine (BT) resin, polycarbonate (PC) resin, build-up films such as Ajinomoto build-up film (ABF), or other laminate resins.

The multiple wiring layers may be arranged in the body layer. For example, the multiple wiring layers may include 8 to 20 wiring layers. However, the number of layers of the multiple wiring layers is not limited to the range described above. On the other hand, wirings in different layers may be connected to each other through vertical vias. Each of the wirings and the vertical vias may include, for example, copper (Cu). However, the material of each of the wirings and the vertical vias is not limited to Cu.

The protective layer may protect the body layer and the multiple wiring layers from external physical and chemical damage. The protective layer may include an upper protective layer and a lower protective layer. The protective layer may include, for example, solder resist (SR). However, the material of the protective layer is not limited to SR.

The lower semiconductor chip 100-1 may be stacked on the package substrate 200 through an adhesive layer 105, and the upper semiconductor chip 100-2 may be stacked on the lower semiconductor chip 100-1 through an adhesive layer 105. In addition, the two semiconductor chips 100-1 and 100-2, that is, the lower semiconductor chip 100-1 and the upper semiconductor chip 100-2, may be electrically connected to the package substrate 200 through wirings 150. For example, chip pads 140 of the two semiconductor chips 100-1 and 100-2 and a substrate pad 210 of the package substrate 200 may be connected to each other through the wirings 150.

In the semiconductor package 1000 according to the present example embodiment, the two semiconductor chips 100-1 and 100-2 may be, for example, the first semiconductor chip 100La of the semiconductor device 100a of FIG. 2A. However, the inventive concepts are not limited thereto, and the two semiconductor chips 100-1 and 100-2 may be the second semiconductor chip 100Ra of the semiconductor device 100a of FIG. 2A. The two semiconductor chips 100-1 and 100-2 may respectively have the chip pads 140 disposed on an upper surface of a chip corresponding to a peripheral area 130. In addition, in the semiconductor package 1000 according to the present example embodiment, two semiconductor chips 100-1 and 100-2 may be disposed on the package substrate 200 so that longer sides thereof face the y direction. Accordingly, the chip pads 140 of the two semiconductor chips 100-1 and 100-2 may be arranged in the y direction (e.g. spaced along the y direction). On the other hand, as illustrated in FIGS. 11A and 11B, the two semiconductor chips 100-1 and 100-2 may be stacked in a stepped structure in the x direction, and thus, the chip pads 140 of the lower semiconductor chip 100-1 may be exposed to the outside.

The sealant 300 may cover and seal the semiconductor chips 100-1 and 100-2 and the wirings 150 on the package substrate 200. The sealant 300 may seal the semiconductor chips 100-1 and 100-2 so as to protect the semiconductor chips 100-1 and 100-2 from external physical and chemical damage. The sealant 300 may be formed of, for example, epoxy molding compound (EMC). However, the sealant 300 is not limited to EMC and may be formed of various materials, such as epoxy-based materials, thermosetting materials, thermoplastic materials, or ultraviolet (UV) curable materials. In addition, the sealant 300 may be formed of resin and may include a filler.

In addition, the semiconductor package 1000 according to the present example embodiment may be classified into two types depending on the types of stacked semiconductor chips 100-1 and 100-2. For example, the semiconductor package 1000 may be classified into a semiconductor package of a first type including the first semiconductor chip 100La of the semiconductor device 100a of FIG. 2A and a semiconductor package of a second type including the second semiconductor chip 100Ra of the semiconductor device 100a of FIG. 2A. On the other hand, although the structure in which two semiconductor chips are stacked on the package substrate 200 is illustrated, the number of semiconductor chips stacked on the package substrate 200 is not limited to two. For example, in the semiconductor package 1000 according to the present example embodiment, three or more semiconductor chips may be stacked on the package substrate 200.

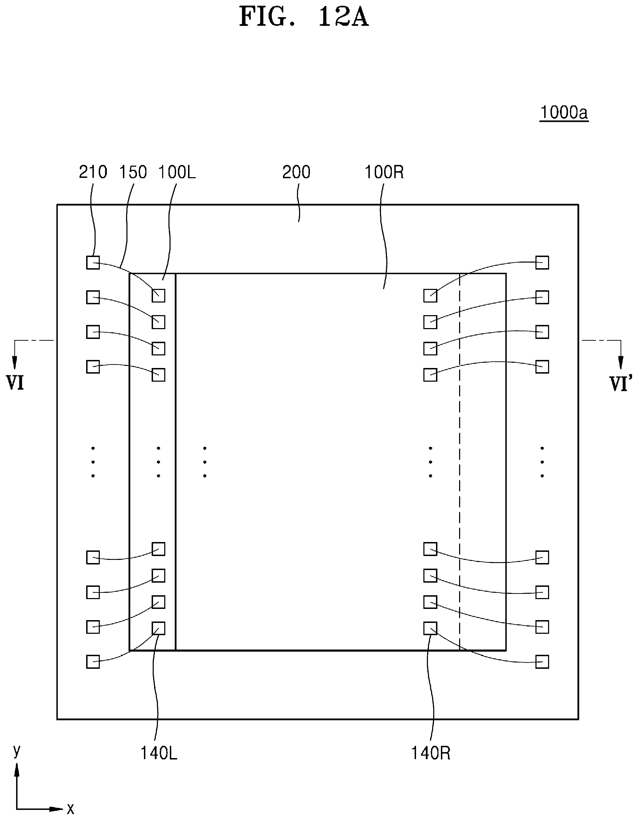

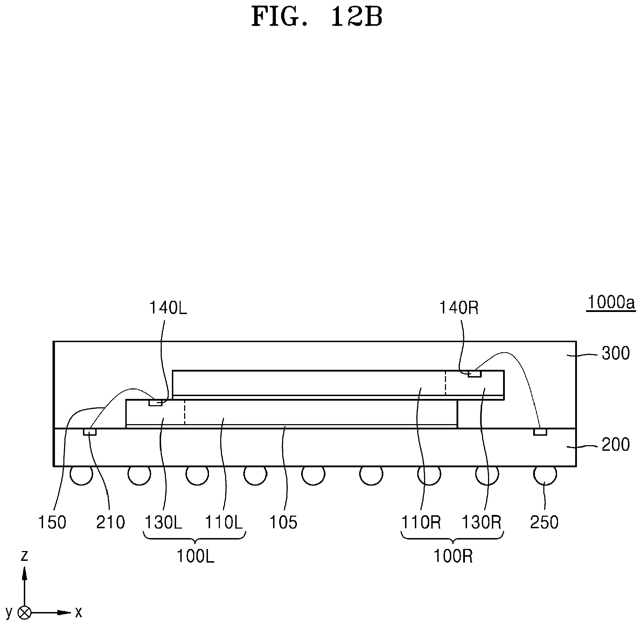

FIGS. 12A and 12B are respectively a plan view and a cross-sectional view of a semiconductor package including a semiconductor device, according to an example embodiment. FIG. 12B is a cross-sectional view taken along line VI-VI' of FIG. 12A. The following description is given with reference to FIGS. 1A and 1B together, and elements provided above with reference to FIGS. 11A and 11B are briefly described or omitted.

Referring to FIGS. 12A and 12B, a semiconductor package 1000a according to the present example embodiment may differ from the semiconductor package 1000 of FIG. 11A in that two types of semiconductor chips 100L and 100R are stacked on a package substrate 200. For example, in the semiconductor package 1000a according to the present example embodiment, the first semiconductor chip 100L may be stacked on the package substrate 200 through an adhesive layer 105, and the second semiconductor chip 100R may be stacked on the first semiconductor chip 100L through an adhesive layer 105.

In the semiconductor package 1000a according to the present example embodiment, the first semiconductor chip 100L and the second semiconductor chip 100R may be the first semiconductor chip 100La and the second semiconductor chip 100Ra of the semiconductor device 100a of FIG. 2A. In addition, the first semiconductor chip 100L and the second semiconductor chip 100R may be arranged on the package substrate 200 so that longer sides thereof face the y direction. Accordingly, first chip pads 140L of the first semiconductor chip 100L may be arranged in the y direction on an upper surface of a chip corresponding to a first peripheral area 130L that is on the left side in the x direction. In addition, second chip pads 140R of the second semiconductor chip 100R may be arranged in the y direction on an upper surface of a chip corresponding to a second peripheral area 130R that is on the right side in the x direction.

The first semiconductor chip 100L may be connected to a substrate pad 210 arranged on the left side of the package substrate 200 in the x direction through a wiring 150, and the second semiconductor chip 100R may be connected to a substrate pad 210 arranged on the right side of the package substrate 200 in the x direction through a wiring 150. In addition, based on the mirror-symmetrical structure of the first semiconductor chip 100L and the second semiconductor chip 100R, the substrate pads 210 on the package substrate 200 may be arranged in a symmetrical structure. Due to the symmetrical structure of the substrate pads 210, the wiring structure inside the package substrate 200 may be simplified and the degree of freedom of wiring may be improved.

On the other hand, in the semiconductor package 1000a according to the present example embodiment, the first semiconductor chip 100L and the second semiconductor chip 100R may be stacked on the package substrate 200 in a stepped structure in the x direction. Accordingly, the first chip pads 140L of the first semiconductor chip 100L may be exposed to the outside.

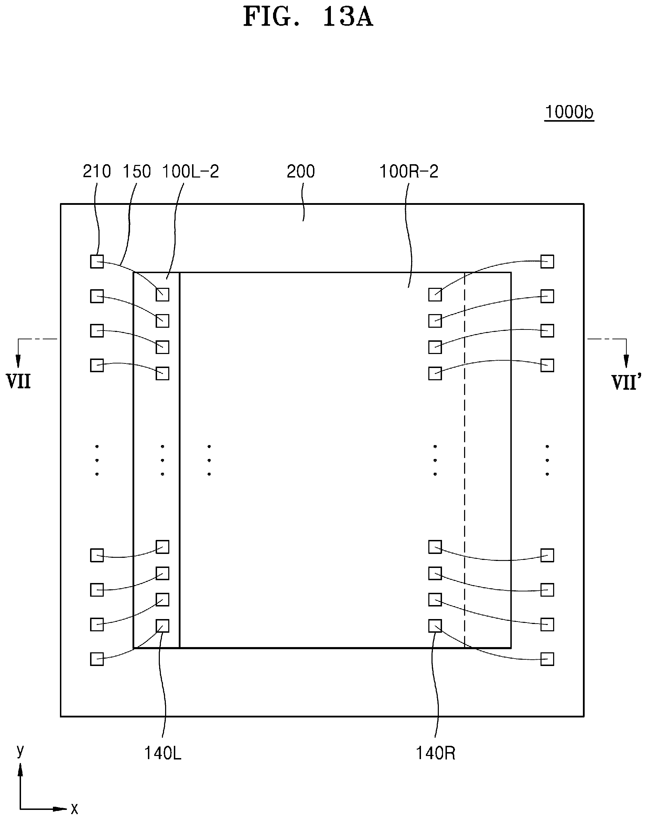

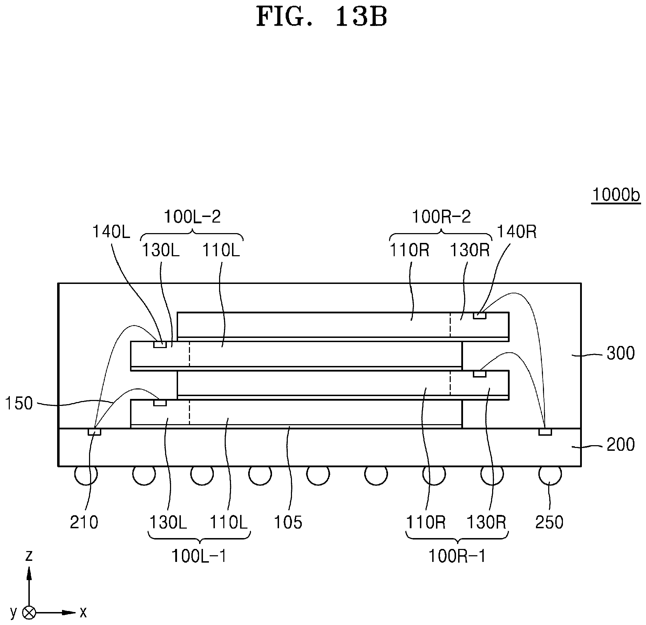

FIGS. 13A and 13B are respectively a plan view and a cross-sectional view of a semiconductor package including a semiconductor device, according to an example embodiment. FIG. 13B is a cross-sectional view taken along line VII-VII' of FIG. 13A. The following description is given with reference to FIGS. 1A and 1B together, and elements provided above with reference to FIGS. 11A to 12B are briefly described or omitted.

Referring to FIGS. 13A and 13B, a semiconductor package 1000b according to the present example embodiment may differ from the semiconductor package 1000a of FIG. 12A in that two types of four semiconductor chips 100L-1, 100L-2, 100R-1, and 100R-2 are stacked on a package substrate 200. For example, in the semiconductor package 1000b according to the present example embodiment, the lower first semiconductor chip 100L-1 may be stacked on the package substrate 200, the lower second semiconductor chip 100R-1 may be stacked on the lower first semiconductor chip 100L-1, the upper first semiconductor chip 100L-2 may be stacked on the lower second semiconductor chip 100R-1, and the upper second semiconductor chip 100R-2 may be stacked on the upper first semiconductor chip 100L-2.

In the semiconductor package 1000b according to the present example embodiment, the lower and upper first semiconductor chips 100L-1 and 100L-2 may be the first semiconductor chip 100La of the semiconductor device 100a of FIG. 2A, and the lower and upper second semiconductor chips 100R-1 and 100R-2 may be the second semiconductor chip 100Ra of the semiconductor device 100a of FIG. 2A. In addition, the lower and upper first semiconductor chips 100L-1 and 100L-2 and the lower and upper second semiconductor chips 100R-1 and 100R-2 may be arranged on the package substrate 200 so that longer sides thereof face the y direction. Accordingly, first chip pads 140L of each of the lower and upper first semiconductor chips 100L-1 and 100R-2 may be arranged in the y direction on an upper surface of a chip corresponding to a first peripheral area 130L that is on the left side in the x direction. In addition, second chip pads 140R of the lower and upper second semiconductor chips 100R-1 and 100R-2 may be arranged in the y direction on an upper surface of a chip corresponding to a second peripheral area 130R that is on the right side in the x direction.

The lower and upper first semiconductor chips 100L-1 and 100L-2 may be connected through a wiring 150 to the substrate pad 210 arranged on the left side of the package substrate 200 in the x direction, and the lower and upper second semiconductor chips 100R-1 and 100R-2 may be connected through a wiring 150 to the substrate pad 210 arranged on the right side of the package substrate 200 in the x direction. In addition, based on the mirror-symmetrical structure of the first semiconductor chips 100L-1 and 100L-2 and the second semiconductor chips 100R-1 and 100R-2, the substrate pads 210 on the package substrate 200 may be arranged in a symmetrical structure. Due to the symmetrical structure of the substrate pads 210, the wiring structure inside the package substrate 200 may be simplified and the degree of freedom of wiring may be improved.

The semiconductor package 1000b according to the present example embodiment, the lower and upper first semiconductor chips 100L-1 and 100L-2 and the lower and upper second semiconductor chips 100R-1 and 100R-2 may be stacked on the package substrate 200 in a zigzag structure in the x direction. Accordingly, the first chip pads 140L of the lower and upper first semiconductor chips 100L-1 and 100L-2 and the second chip pads 140R of the lower second semiconductor chip 100R-1 may be exposed to the outside.

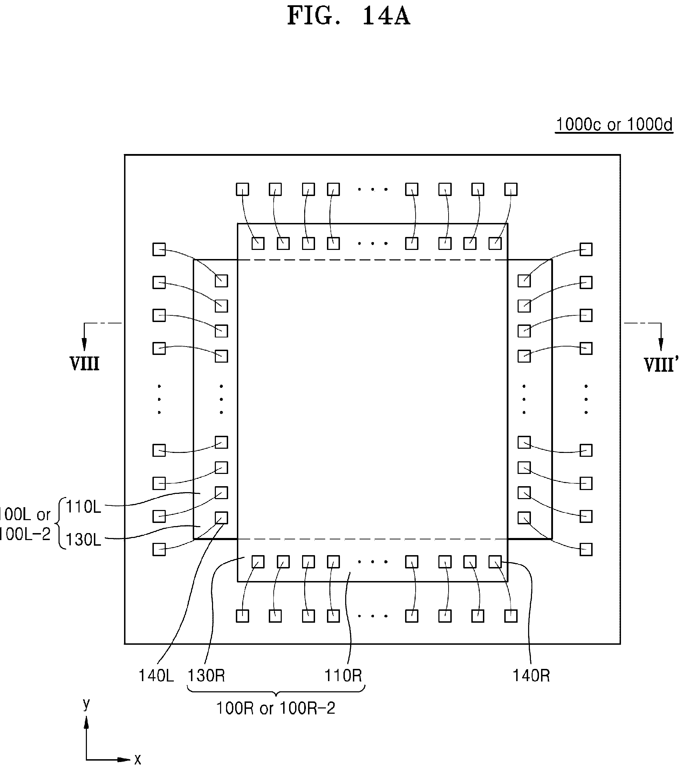

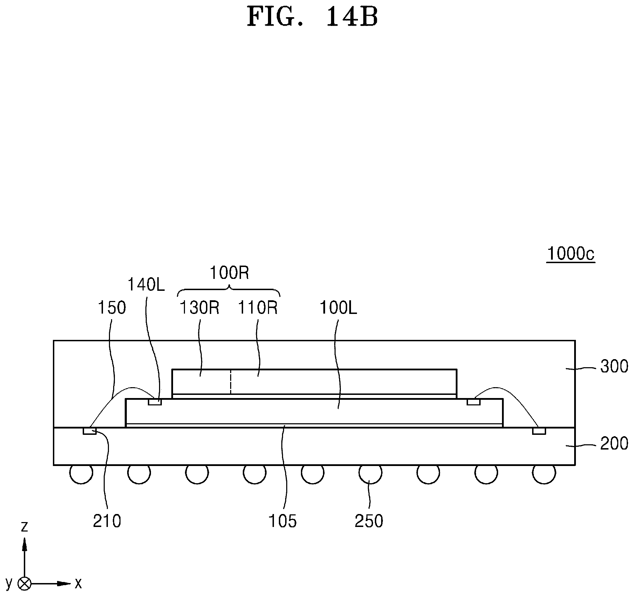

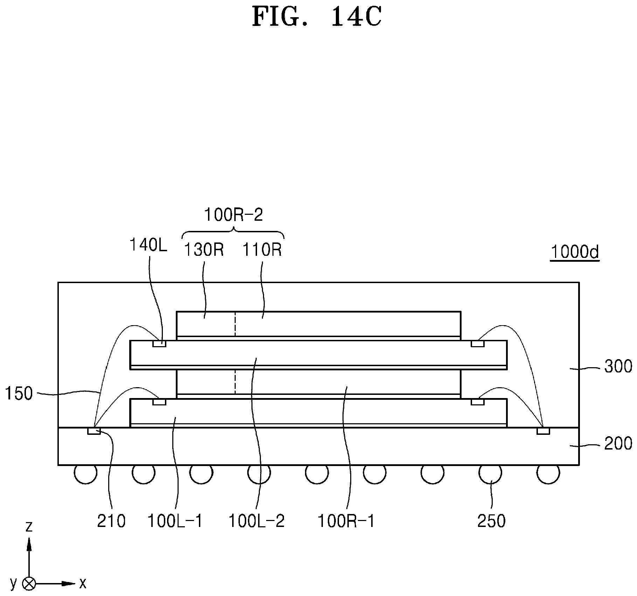

FIGS. 14A to 14C are a plan view and cross-sectional views of a semiconductor package including a semiconductor device, according to an example embodiment. FIGS. 14B and 14C are cross-sectional views taken along line VIII-VIII' of FIG. 14A. The following description is given with reference to FIGS. 1A and 1B together, and elements provided above with reference to FIGS. 11A to 13B are briefly described or omitted.

Referring to FIGS. 14A and 14B, a semiconductor package 1000c according to the present example embodiment may differ from the semiconductor package 1000 of FIG. 11A in that two types of semiconductor chips are stacked on a package substrate 200 so that longer sides thereof face different directions. For example, in the semiconductor package 1000c according to the present example embodiment, a first semiconductor chip 100L may be stacked on the package substrate 200 through an adhesive layer 105, and a second semiconductor chip 100R may be stacked on the first semiconductor chip 100L through an adhesive layer 105.

In the semiconductor package 1000c according to the present example embodiment, the first semiconductor chip 100L and the second semiconductor chip 100R may be respectively the first semiconductor chip 100Lb and the second semiconductor chip 100Rb of the semiconductor device 100b of FIG. 2B. In addition, the first semiconductor chip 100L may be disposed on the package substrate 200 so that a longer side thereof faces the y direction (e.g. extends in the x direction), and the second semiconductor chip 100R may be disposed on the package substrate 200 so that a longer side thereof faces the x direction (e.g. extends in the y direction). Accordingly, first chip pads 140L of the first semiconductor chip 100L may be arranged in the y direction on upper surfaces of the first semiconductor chip 100L on both sides in the x direction. In addition, second chip pads 140R of the second semiconductor chip 100R may be arranged in the x direction on upper surfaces of the second semiconductor chip 100R on both sides in the y direction. Because the longer sides of the first semiconductor chip 100L and the second semiconductor chip 100R face different directions, the first semiconductor chip 100L and the second semiconductor chip 100R may form a cross shape.

On the other hand, the first semiconductor chip 100L may be connected through a wiring 150 to a substrate pad 210 arranged on both sides of the package substrate 200 in the x direction, and the second semiconductor chip 100R may be connected through a wiring 150 to a substrate pad 210 arranged on both sides of the package substrate 200 in the y direction. In addition, the substrate pads 210 on the package substrate 200 may be arranged in a symmetrical structure. Due to the symmetrical structure of the substrate pads 210, the wiring structure inside the package substrate 200 may be simplified and the degree of freedom of wiring may be improved.

Referring to FIG. 14C, a semiconductor package 1000d according to the present example embodiment may differ from the semiconductor package 1000c of FIG. 14B in that two types of four semiconductor chips 100L-1, 100L-2, 100R-1, and 100R-2 are stacked on a package substrate 200. For example, in the semiconductor package 1000d according to the present example embodiment, the lower first semiconductor chip 100L-1 may be stacked on the package substrate 200, the lower second semiconductor chip 100R-1 may be stacked on the lower first semiconductor chip 100L-1, the upper first semiconductor chip 100L-2 may be stacked on the lower second semiconductor chip 100R-1, and the upper second semiconductor chip 100R-2 may be stacked on the upper first semiconductor chip 100L-2.

In addition, in the semiconductor package 1000d according to the present example embodiment, the lower and upper first semiconductor chips 100L-1 and 100L-2 may be the first semiconductor chip 100Lb of the semiconductor device 100b of FIG. 2B, and the lower and upper second semiconductor chips 100R-1 and 100R-2 may be the second semiconductor chip 100Rb of the semiconductor device 100b of FIG. 2B. The semiconductor package 1000d according to the present example embodiment may be similar to the structure of the semiconductor package 1000c of FIG. 14B, except that an upper first semiconductor chip 100L-2 and an upper second semiconductor chip 100R-2 are further stacked.

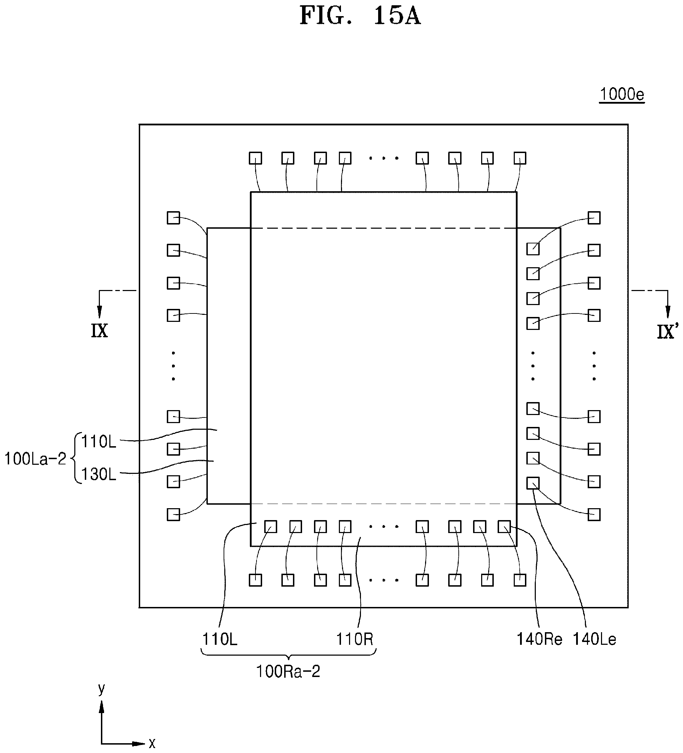

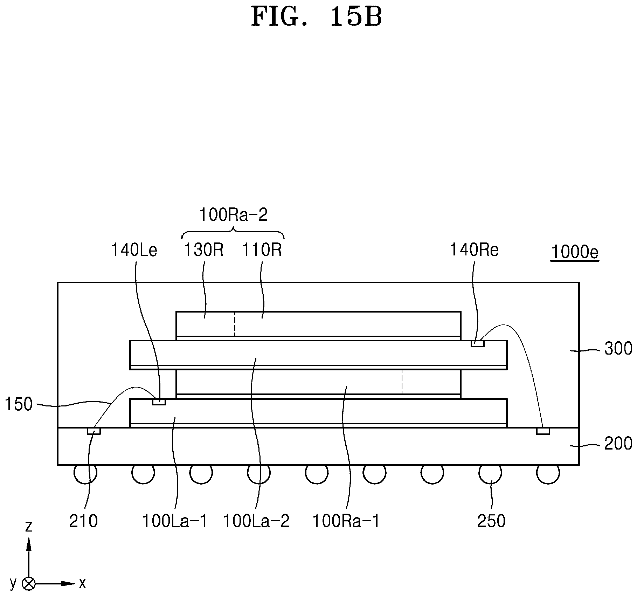

FIGS. 15A and 15B are a plan view and a cross-sectional view of a semiconductor package including a semiconductor device, according to an example embodiment. FIG. 15B is a cross-sectional view taken along line IX-IX' of FIG. 15A. The following description is given with reference to FIGS. 1A and 1B together, and elements provided above with reference to FIGS. 11A to 14B are briefly described or omitted.

Referring to FIGS. 15A and 15B, a semiconductor package 1000e according to an example embodiment is similar to the semiconductor package 1000d of FIG. 14C in that two types of four semiconductor chips 100La-1, 100La-2, 100Ra-1, and 100Ra-2 are stacked, but differs from the semiconductor package 1000d of FIG. 14C in the structure of chip pads 140Le and 140Re of the semiconductor chips 100La-1, 100La-2, 100Ra-1, and 100Ra-2. For example, in the semiconductor package 1000e according to the present example embodiment, the lower first semiconductor chip 100La-1 may be stacked on the package substrate 200, the lower second semiconductor chip 100Ra-1 may be stacked on the lower first semiconductor chip 100La-1, the upper first semiconductor chip 100La-2 may be stacked on the lower second semiconductor chip 100Ra-1, and the upper second semiconductor chip 100Ra-2 may be stacked on the upper first semiconductor chip 100La-2. In addition, the first chip pads 140Le of the lower first semiconductor chip 100La-1 may be disposed in the y direction on an upper surface of the lower first semiconductor chip 100La-1 that is on the left side in the x direction, and the first chip pads 140Le of the upper first semiconductor chip 100La-2 may be disposed in the y direction on a portion of an upper surface of the upper first semiconductor chip 100La-2 that is on the right side in the x direction. On the other hand, the second chip pads 140Re of the lower second semiconductor chip 100Ra-1 may be disposed in the y direction on a portion of an upper surface of the lower second semiconductor chip 100Ra-1 that is on the upper side in the y direction, and the second chip pads 140Re of the upper second semiconductor chip 100Ra-2 may be disposed in the x direction on a portion of an upper surface of the upper second semiconductor chip 100Ra-2 that is on the lower side in the y direction.

In the semiconductor package 1000e according to the present example embodiment, the lower and upper first semiconductor chips 100La-1 and 100La-2 may be disposed on the package substrate 200 so that longer sides thereof face the y direction (e.g. extend in the x direction), and the lower and upper second semiconductor chips 100Ra-1 and 100Ra-2 may be disposed on the package substrate 200 so that longer sides thereof face the x direction (e.g. extend in the y direction). Accordingly, the first chip pad 140Le of the lower first semiconductor chip 100La-1 may be connected to the substrate pad 210 disposed on the left side of the package substrate 200 in the x direction, the second chip pad 140Re of the lower second semiconductor chip 100Ra-1 may be connected to the substrate pad 210 disposed on the upper side of the package substrate 200 in the y direction, the first chip pad 140Le of the upper first semiconductor chip 100La-2 may be connected to the substrate pad 210 disposed on the right side of the package substrate 200 in the x direction, and the second chip pad 140Re of the upper second semiconductor chip 100Ra-2 may be connected to the substrate pad 210 disposed on the lower side of the package substrate 200 in the y direction. Therefore, the chip pads 140Le and 140Re of the four semiconductor chips 100La-1, 100La-2, 100Ra-1, and 100Ra-2 may be connected to the substrate pads 210 on the four sides of the corresponding package substrate 200.

The first semiconductor chips 100La-1 and 100La-2 may be mirror-symmetrical to the second semiconductor chips 100Ra-1 and 100Ra-2. Accordingly, the substrate pads 210 on the package substrate 200 may also be arranged in a symmetrical structure. Due to the symmetrical structure of the substrate pads 210, the wiring structure inside the package substrate 200 may be simplified and the degree of freedom of wiring may be improved.

In the embodiments of FIG. 11A-15, first and second semiconductor chips are stacked one atop another. Nevertheless, the structure of these chips is mirror-symmetrical. That is, if the chips were arranged (e.g. positioned) side by side (e.g. adjacent in the x direction), their structures would be symmetrical along an axis in the y direction.

Embodiments are set out in the following clauses:
Clause 1. A semiconductor device comprising:
   a first semiconductor chip of a first type and a second semiconductor chip of a second type having rectangular shapes with a same size,
   wherein the first semiconductor chip and the second semiconductor chip are included in a plurality of semiconductor chips corresponding to 1-shot in an exposure process, and
   when the first semiconductor chip and the second semiconductor chip are arranged adjacent to each other in a first direction in the 1-shot, the first semiconductor chip and the second semiconductor chip are mirror-symmetrical to each other with respect to an axis in a second direction perpendicular to the first direction.
Clause 2. The semiconductor device of Clause 1, wherein, in a state of being mirror-symmetrical,
   an extension area of the first semiconductor chip is arranged on a left side of a cell area of the first semiconductor chip in the first direction, and an extension area of the second semiconductor chip is arranged on a right side of a cell area of the second semiconductor chip in the first direction, or the extension area of the first semiconductor chip is arranged on a right side of the cell area of the first semiconductor chip in the first direction, the extension area of the second semiconductor chip is arranged on a left side of the cell area of the second semiconductor chip in the first direction, and
   a peripheral area of each of the first semiconductor chip and the second semiconductor chip are below the cell area of a corresponding one of the first semiconductor chip and the second semiconductor chip in the second direction.
Clause 3. The semiconductor device of Clause 2, wherein a plurality of first chip pads on a front surface of the first semiconductor chip and a plurality of second chip pads on a front surface of the second semiconductor chip are arranged at different positions.
Clause 4. The semiconductor device of Clause 3, wherein
   the first chip pads are arranged in the first direction on the peripheral area of the first semiconductor chip, and
   the second chip pads are arranged in the first direction on the peripheral area of the second semiconductor chip.
Clause 5. The semiconductor device of Clause 3, wherein
   the first chip pads are arranged in the first direction on the peripheral area of the first semiconductor chip, and
   the second chip pads are arranged in the first direction on a side of the front surface of the second semiconductor chip that is opposite to a side at which the peripheral area of the first semiconductor chip is provided.
Clause 6. The semiconductor device of Clause 3, wherein
   the first chip pads are arranged in the second direction on the front surface of the first semiconductor chip and are on both outer portions in the first direction of the first semiconductor chip, and
   the second chip pads are arranged in the second direction on the front surface of the second semiconductor chip and are at a central portion thereof in the first direction.
Clause 7. A semiconductor package comprising:
   a package substrate;
   a first semiconductor chip of a first type on the package substrate; and
   a second semiconductor chip of a second type stacked on the first semiconductor chip,
   wherein the first semiconductor chip and the second semiconductor chip have rectangular shapes with a same size, and
   when arranged in a first direction, the first semiconductor chip and the second semiconductor chip are mirror-symmetrical to each other with respect to a reference line extending in a second direction perpendicular to the first direction.
Clause 8. The semiconductor package of Clause 7, wherein, in a state of being mirror-symmetrical,
   an extension area of the first semiconductor chip is arranged on a left side of a cell area of the first semiconductor chip in the first direction, and an extension area of the second semiconductor chip is arranged on a right side of a cell area of the second semiconductor chip in the first direction, or
   the extension area of the first semiconductor chip is arranged on a right side of the cell area of the first semiconductor chip in the first direction, and the extension area of the second semiconductor chip is arranged on a left side of the cell area of the second semiconductor chip in the first direction, and
   a peripheral area of each of the first semiconductor chip and the second semiconductor chip are below the cell area of a corresponding one of the first semiconductor chip and the second semiconductor chip in the second direction.
Clause 9. The semiconductor package of Clause 8, wherein
   a longer side of each of the first semiconductor chip and the second semiconductor chip is arranged in the second direction,
   a plurality of first chip pads of the first semiconductor chip are arranged in the second direction at a left outer portion in the first direction of a front surface of the first semiconductor chip, and
   a plurality of second chip pads of the second semiconductor chip are arranged in the second direction at a right outer portion in the first direction of a front surface of the second semiconductor chip .
Clause 10. The semiconductor package of Clause 9, wherein
   the first chip pads are on a portion of the front surface of the first semiconductor chip corresponding to the peripheral area of the first semiconductor chip, and
   the second chip pads are on a portion of the front surface of the first semiconductor chip corresponding to the peripheral area of the second semiconductor chip.
Clause 11. The semiconductor package of Clause 9 or Clause 10, wherein the second semiconductor chip is stacked on the first semiconductor chip in a stepped structure in the first direction so that the first chip pads are exposed.
Clause 12. The semiconductor package of any of Clauses 8-11, wherein
   a longer side of the first semiconductor chip is arranged on the package substrate in the first direction, and a longer side of the second semiconductor chip is arranged on the package substrate in the second direction so as to form a cross shape with the first semiconductor chip,
   a plurality of first chip pads of the first semiconductor chip are arranged in the second direction and are at both outer portions of a front surface of the first semiconductor chip in the first direction, and
   a plurality of second chip pads of the second semiconductor chip are arranged in the first direction and are at both outer portions of a front surface of the second semiconductor chip in the second direction.
Clause 13. The semiconductor package of Clause 12, wherein
   a third semiconductor chip of the first type is stacked on the second semiconductor chip, and a fourth semiconductor chip of the second type is stacked on the third semiconductor chip,
   a longer side of the third semiconductor chip is arranged in a first direction, and a longer side of the fourth semiconductor chip is arranged in a second direction,
   a plurality of third chip pads of the third semiconductor chip are arranged in the second direction and at both outer portions of a front surface of the third semiconductor chip in the first direction, and
   a plurality of fourth chip pads of the fourth semiconductor chip are arranged in the first direction and at both outer portions of a front surface of the fourth semiconductor chip in the second direction.
Clause 14. The semiconductor package of any of Clauses 8-12, further comprising:
   at least one third semiconductor chip of the first type on the second semiconductor chip.
Clause 15. The semiconductor package of Clause 14, wherein
   the first, second, and third semiconductor chips are stacked in a stepped structure or a zigzag structure in the first direction, or
   two vertically adjacent ones from among the first, second, and third semiconductor chips are stacked to have a cross shape.
Clause 16. The semiconductor package of Clause 14 or Clause 15, wherein
   a plurality of first chips pad of the first semiconductor chip is arranged along a first side of four sides of the package substrate,
   a plurality of second chip pads of the second semiconductor chip is arranged along a second side of the four sides of the package substrate, and
   a plurality of third chip pads of the third semiconductor chip is arranged along a third side of the four sides of the package substrate.
Clause 17. A semiconductor package comprising:
   a package substrate;
   at least one first semiconductor chip of a first type on the package substrate; and
   at least one second semiconductor chip of a second type on the package substrate,
   wherein the at least one first semiconductor chip and the at least one second semiconductor chip have rectangular shapes with a same size,
   when the at least one first semiconductor chip and the at least one second semiconductor chip are arranged adjacent to each other in a first direction in 1-shot in an exposure process, the at least one first semiconductor chip and the at least one second semiconductor chip are mirror-symmetrical to each other with respect to a reference line extending in a second direction perpendicular to the first direction, and
   the at least one first semiconductor chip of the first type and the at least one second semiconductor chip of the second type are alternately stacked on the package substrate.
Clause 18. The semiconductor package of Clause 17, wherein, in a state of being mirror-symmetrical,
   an extension area of the at least one first semiconductor chip is arranged on a left side of a cell area of the first semiconductor in the first direction, and an extension area of the at least one second semiconductor chip is arranged on a right side of the cell area of the second semiconductor in the first direction, or
   the extension area of the at least one first semiconductor chip is arranged on a right side of the cell area of the first semiconductor in the first direction, and the extension area of the at least one second semiconductor chip is arranged on a left side of the cell area of the second semiconductor in the first direction, and
   a peripheral area of each of the at least one first semiconductor chip and the at least one second semiconductor chip are below the cell area a corresponding one of the first semiconductor chip and the second semiconductor chip in the second direction.
Clause 19. The semiconductor package of Clause 18, wherein
   a longer side of each of the at least one first semiconductor chip and the at least one second semiconductor chip is arranged in the second direction,
   a plurality of first chip pads of the at least one first semiconductor chip are arranged in the second direction at a left outer portion in the first direction of a front surface of the first semiconductor chip in the first direction, and
   a plurality of second chip pads of the at least one second semiconductor chip are arranged in the second direction at a right outer portion in the first direction of a front surface of the second semiconductor chip.
Clause 20. The semiconductor package of Clause 18 or Clause 19, wherein
   a longer side of the at least one first semiconductor chip is in the first direction, a longer side of the at least one second semiconductor chip is in the second direction so as to form a cross shape with the first semiconductor chip,
   a plurality of first chip pads of the at least one first semiconductor chip are arranged in the second direction at both outer portions in the first direction of a front surface of the first semiconductor chip, and
   a plurality of second chip pads of the at least one second semiconductor chip are arranged in the first direction at both outer portions in the second direction of a front surface of the second semiconductor chip.
Clause 21. A method of manufacturing a semiconductor device, the method comprising:
   preparing a mask;
   forming a pattern on a wafer through an exposure process using the mask;
   determining whether a semiconductor device is completely formed;
   in response to a result of the determining indicating that the semiconductor device has been completely formed, singulating the wafer into a plurality of semiconductor chips; and
   in response to the result of the determining indicating that the semiconductor device has not been completely formed, returning to the preparing of the mask to prepare another mask corresponding to a next pattern,
   wherein, in the forming of the pattern, 1-shot, which is an area of the pattern transferred through one exposure process, is formed to have a structure including the plurality of semiconductor chips that are mirror-symmetrical or origin-symmetrical to each other.
Clause 22. The method of Clause 21, wherein
   the plurality of semiconductor chips included in the 1-shot comprise a first semiconductor chip of a first type and a second semiconductor chip of a second type that are arranged adjacent to each other in a first direction within the 1-shot, and
   the first semiconductor chip and the second semiconductor chip are mirror-symmetrical to each other with respect to an axis in a second direction perpendicular to the first direction.
Clause 23. The method of Clause 22, wherein, in the 1-shot,
   an extension area of the first semiconductor chip is arranged on a left side in the first direction of a cell area of the first semiconductor chip, and an extension area of the second semiconductor chip is arranged on a right side in the first direction of a cell area of the second semiconductor chip, or
   the extension area of the first semiconductor chip is arranged on a right side in the first direction of the cell area of the first semiconductor chip, and the extension area of the second semiconductor chip is arranged on a left side in the first direction of the cell area of the second semiconductor chip, and
   a peripheral area of each of the first semiconductor chip and the second semiconductor chip are below the cell area of a corresponding one of the first semiconductor chip and the second semiconductor chip in the second direction.
Clause 24. The method of Clause 22 or Clause 23, wherein at least two first semiconductor chips and at least two second semiconductor chips are arranged in the second direction within the 1-shot.
Clause 25. The method of any of Clauses 21-14, wherein
   a plurality of semiconductor chips included in the 1-shot comprise four semiconductor chips that are arranged in quadrants, two first semiconductor chips being arranged in first and third quadrants and two second semiconductor chips being arranged in second and fourth quadrants, or the two second semiconductor chips being arranged in the first and third quadrants and the two first semiconductor chips being arranged in the second and fourth quadrants,
   the two first semiconductor chips are origin-symmetrical to each other with respect to an origin of the quadrants, and
   the two second semiconductor chips are origin-symmetrical to each other with respect to the origin of the quadrants.
Clause 26. The method of Clause 25, wherein, in the 1-shot,
   an extension area of one of the two first semiconductor chips is arranged on a left side in a first direction of a cell area of the one of the two first semiconductor chips, an extension area of one of the two second semiconductor chips that is adjacent to the one of the two first semiconductor chips in the first direction is arranged on a right side in the first direction of the cell area of the one of the two second semiconductor chips, or
   an extension area of the other one of the two first semiconductor chips is arranged on a right side in the first direction of the cell area of the other one of the two first semiconductor chips, and an extension area of the other one of the two second semiconductor chips that is adjacent to the other one of the two first semiconductor chips in the first direction is arranged on a left side of the cell area of the other one of the two second semiconductor chips, and
   a peripheral are of each of the two first semiconductor chips and the two second semiconductor chips, which are adjacent to the two first semiconductor chips in the first direction, respectively, are below or above the cell area of a corresponding one of the two first semiconductor chips and the two second semiconductor chips in a second direction perpendicular to the first direction.
Clause 27. The method of Clause 25 or Clause 26, wherein, in the 1-shot, an even number of the first semiconductor chips and an even number of the second semiconductor chips are arranged in a second direction perpendicular to a first direction along which one of the first semiconductor chips and a corresponding ones of the second semiconductor chips are arranged.
Clause 28. The method of any of Clauses 21-27, wherein, in another 1-shot for forming chip pads, a plurality of first chip pads of a first semiconductor chip included in the plurality of semiconductor chips and a plurality of second chip pads of a second semiconductor chip included in the plurality of semiconductor chips and adjacent to the first semiconductor chip in a first direction within the 1-shot are not mirror-symmetrical to each other.
Clause 29. A semiconductor device comprising:
   a first semiconductor chip of a first type and a second semiconductor chip of a second type having rectangular shapes with a same size,
   wherein the first semiconductor chip and the second semiconductor chip are included in a plurality of semiconductor chips, and
   the first semiconductor chip and the second semiconductor chip are arranged adjacent to each other in a first direction, and the first semiconductor chip and the second semiconductor chip are mirror-symmetrical to each other with respect to an axis in a second direction perpendicular to the first direction.

While the inventive concepts have been particularly shown and described with reference to some example embodiments thereof, it will be understood that various changes in form and details may be made therein without departing from the scope of the following claims.

## Claims

1. A semiconductor device comprising:
a first semiconductor chip of a first type and a second semiconductor chip of a second type having rectangular shapes with a same size,
wherein the first semiconductor chip and the second semiconductor chip are included in a plurality of semiconductor chips corresponding to 1-shot in an exposure process, and
when the first semiconductor chip and the second semiconductor chip are arranged adjacent to each other in a first direction in the 1-shot, the first semiconductor chip and the second semiconductor chip are mirror-symmetrical to each other with respect to an axis in a second direction perpendicular to the first direction.

2. The semiconductor device of claim 1, wherein, in a state of being mirror-symmetrical,
an extension area of the first semiconductor chip is arranged on a left side of a cell area of the first semiconductor chip in the first direction, and an extension area of the second semiconductor chip is arranged on a right side of a cell area of the second semiconductor chip in the first direction, or the extension area of the first semiconductor chip is arranged on a right side of the cell area of the first semiconductor chip in the first direction, the extension area of the second semiconductor chip is arranged on a left side of the cell area of the second semiconductor chip in the first direction, and
a peripheral area of each of the first semiconductor chip and the second semiconductor chip are below the cell area of a corresponding one of the first semiconductor chip and the second semiconductor chip in the second direction.

3. The semiconductor device of claim 2, wherein a plurality of first chip pads on a front surface of the first semiconductor chip and a plurality of second chip pads on a front surface of the second semiconductor chip are arranged at different positions.

4. A semiconductor package comprising:
a package substrate;
a first semiconductor chip of a first type on the package substrate; and
a second semiconductor chip of a second type stacked on the first semiconductor chip,
wherein the first semiconductor chip and the second semiconductor chip have rectangular shapes with a same size, and
when arranged in a first direction, the first semiconductor chip and the second semiconductor chip are mirror-symmetrical to each other with respect to a reference line extending in a second direction perpendicular to the first direction.

5. The semiconductor package of claim 4, wherein, in a state of being mirror-symmetrical,
an extension area of the first semiconductor chip is arranged on a left side of a cell area of the first semiconductor chip in the first direction, and an extension area of the second semiconductor chip is arranged on a right side of a cell area of the second semiconductor chip in the first direction, or
the extension area of the first semiconductor chip is arranged on a right side of the cell area of the first semiconductor chip in the first direction, and the extension area of the second semiconductor chip is arranged on a left side of the cell area of the second semiconductor chip in the first direction, and
a peripheral area of each of the first semiconductor chip and the second semiconductor chip are below the cell area of a corresponding one of the first semiconductor chip and the second semiconductor chip in the second direction.

6. The semiconductor package of claim 5, wherein
a longer side of each of the first semiconductor chip and the second semiconductor chip is arranged in the second direction,
a plurality of first chip pads of the first semiconductor chip are arranged in the second direction at a left outer portion in the first direction of a front surface of the first semiconductor chip, and
a plurality of second chip pads of the second semiconductor chip are arranged in the second direction at a right outer portion in the first direction of a front surface of the second semiconductor chip.

7. The semiconductor package of claim 6, wherein
the first chip pads are on a portion of the front surface of the first semiconductor chip corresponding to the peripheral area of the first semiconductor chip, and
the second chip pads are on a portion of the front surface of the first semiconductor chip corresponding to the peripheral area of the second semiconductor chip.

8. The semiconductor package of claim 6 or claim 7, wherein the second semiconductor chip is stacked on the first semiconductor chip in a stepped structure in the first direction so that the first chip pads are exposed.

9. The semiconductor package of claim 5, wherein
a longer side of the first semiconductor chip is arranged on the package substrate in the first direction, and a longer side of the second semiconductor chip is arranged on the package substrate in the second direction so as to form a cross shape with the first semiconductor chip,
a plurality of first chip pads of the first semiconductor chip are arranged in the second direction and are at both outer portions of a front surface of the first semiconductor chip in the first direction, and
a plurality of second chip pads of the second semiconductor chip are arranged in the first direction and are at both outer portions of a front surface of the second semiconductor chip in the second direction.

10. The semiconductor package of any of claims 5-9, further comprising:
at least one third semiconductor chip of the first type on the second semiconductor chip.

11. The semiconductor package of claim 10, wherein
the first, second, and third semiconductor chips are stacked in a stepped structure or a zigzag structure in the first direction, or
two vertically adjacent ones from among the first, second, and third semiconductor chips are stacked to have a cross shape.

12. A method of manufacturing a semiconductor device, the method comprising:
preparing a mask;
forming a pattern on a wafer through an exposure process using the mask;
determining whether a semiconductor device is completely formed;
in response to a result of the determining indicating that the semiconductor device has been completely formed, singulating the wafer into a plurality of semiconductor chips; and
in response to the result of the determining indicating that the semiconductor device has not been completely formed, returning to the preparing of the mask to prepare another mask corresponding to a next pattern,
wherein, in the forming of the pattern, 1-shot, which is an area of the pattern transferred through one exposure process, is formed to have a structure including the plurality of semiconductor chips that are mirror-symmetrical or origin-symmetrical to each other.

13. The method of claim 12, wherein
the plurality of semiconductor chips included in the 1-shot comprise a first semiconductor chip of a first type and a second semiconductor chip of a second type that are arranged adjacent to each other in a first direction within the 1-shot, and
the first semiconductor chip and the second semiconductor chip are mirror-symmetrical to each other with respect to an axis in a second direction perpendicular to the first direction.

14. The method of claim 13, wherein, in the 1-shot,
an extension area of the first semiconductor chip is arranged on a left side in the first direction of a cell area of the first semiconductor chip, and an extension area of the second semiconductor chip is arranged on a right side in the first direction of a cell area of the second semiconductor chip, or
the extension area of the first semiconductor chip is arranged on a right side in the first direction of the cell area of the first semiconductor chip, and the extension area of the second semiconductor chip is arranged on a left side in the first direction of the cell area of the second semiconductor chip, and
a peripheral area of each of the first semiconductor chip and the second semiconductor chip are below the cell area of a corresponding one of the first semiconductor chip and the second semiconductor chip in the second direction.

15. The method of claim 12 or claim 13, wherein
a plurality of semiconductor chips included in the 1-shot comprise four semiconductor chips that are arranged in quadrants, two first semiconductor chips being arranged in first and third quadrants and two second semiconductor chips being arranged in second and fourth quadrants, or the two second semiconductor chips being arranged in the first and third quadrants and the two first semiconductor chips being arranged in the second and fourth quadrants,
the two first semiconductor chips are origin-symmetrical to each other with respect to an origin of the quadrants, and
the two second semiconductor chips are origin-symmetrical to each other with respect to the origin of the quadrants.
